# EUROPEAN PATENT APPLICATION

(11) **EP 1 690 843 A1**
(43) Date of publication of application: **16.08.2006**
(21) Application number: 04819930.1
(22) Date of filing: 03.12.2004
(51) Int. Cl.: C04B 35/475

(54) **PIEZOELECTRIC CERAMIC AND PIEZOELECTRIC DEVICE**

(30) Priority: 04.12.2003 JP 2003405814; 24.12.2003 JP 2003427462; 24.12.2003 JP 2003427399
(71) Applicant: TDK Corporation, Chuo-ku, Tokyo 103-8272 (JP)
(72) Inventor: TSUKADA, Takeo, TDK Corporation, Tokyo, 1038272 (JP); AZUMA, Tomohisa, TDK Corporation, Tokyo, 1038272 (JP); HIROSE, Masakazu, TDK Corporation, Tokyo, 1038272 (JP); OKA, Hitoshi, TDK Corporation, Tokyo, 1038272 (JP)
(74) Representative: Vossius & Partner
(86) International application number: PCT/JP2004/018034
(87) International publication number: WO 2005/054153

(57) **Abstract**

A piezoelectric ceramics having ceramic particles, wherein said ceramic particles comprises bismuth layer compound containing at least Sr, Ln (note that Ln is a lanthanoid element), Bi, Ti and O and including M^{II}Bi₄Ti₄O₁₅ type crystal (M^{II} is an element composed of Sr and Ln) as a main component, and an oxide of Mn as a subcomponent; and an average particle diameter by the code length measuring method is 0.8 to 4.7 µm: by which it is possible to provide piezoelectric ceramics having a large Qₘₐₓ in a third harmonic mode of thickness vertical vibration in a relatively high frequency band (for example, 16 to 65 MHz), a resonator an other piezoelectric element comprising the piezoelectric ceramics as a piezoelectric substance thereof.

## Description

### TECHNICAL FIELD

The present invention relates to piezoelectric ceramics including a bismuth layer composition and a piezoelectric element, such as a resonator using the piezoelectric ceramics as its piezoelectric substance, and particularly relates to piezoelectric ceramics and a piezoelectric element having a large Qₘₐₓ.

### BACKGROUND ART

### 2. Description of the Related Art

Piezoelectric ceramics is a material having a piezoelectric effect of changing an electric polarity by receiving an external stress and a converse piezoelectric effect of causing a distortion by being applied an electric field. Piezoelectric ceramics are used not only in the field of electronic devices, such as a resonator and filter, but widely used for products using charges and potentials, such as a sensor and actuator.

Currently, most of piezoelectric ceramics in practical use are generally ferroelectrics having a perovskite structure of PZT (PbZrO₃ - PbTiO₃ solid solution) having a tetragonal system or rhombohedral system and PT (PbTiO₃) having a tetragonal system. By adding a variety of subcomponents thereto, a variety of demanded characteristics are obtained.

However, many of PZT and PT piezoelectric ceramics in a practical composition have a Curie's point of 200 to 400°C or so, and they become paraelectric at a higher temperature than that and the piezoelectric property is lost. Therefore, they cannot be applied to a use object at a high temperature, for example, a nuclear reactor control sensor, etc.

Also, PZT and PT piezoelectric ceramics as above include a relatively large amount of a lead oxide (PbO) in an amount of 60 to 70 wt% or so, and the lead oxide exhibits high volatility even at a low temperature, which is not preferable in terms of environments.

To solve the above disadvantages, as piezoelectric ceramics having a high Curie's point and not including a lead oxide, those including a bismuth layer compound have been proposed (for example, the Patent Articles 1 to 3). The patent article 1 discloses piezoelectric ceramics including BaBi₄Ti₄O₁₅ as the main crystal phase and a sub crystal phase formed by a composite oxide of Ba and Ti in an amount of 4 to 30 mole% in the entire weight. The patent article 2 discloses piezoelectric ceramics including a bismuth layer compound having Sr, Bi, Ti, Ln (lanthanoid) and SrBi₄Ti₄O₁₅ type crystal, and a Mn oxide. Furthermore, the patent article 3 discloses piezoelectric ceramics including a bismuth layer compound having M^{II} (M^{II} is the element selected from Sr, Ba and Ca), Bi, Ti, O and M^{II}Bi₄Ti₄O₁₅ type crystal.

A resonator as one piezoelectric element is used as an inductor. Therefore, piezoelectric ceramics used as a piezoelectric substance of a resonator is required to have a large Qₘₐₓ. The Qₘₐₓ indicates tanθₘₐₓ when assuming that the maximum value of a phase angle is θₘₐₓ. Namely, when assuming that "X" is reactance and "R" is resistance, it is a maximum value of Q(=|X|/R) between a resonant frequency and antiresonant frequency. Note that the Qₘₐₓ has a property of changing its value due to a measurement frequency, and it is liable that the Qₘₐₓ becomes lower when the measurement frequency becomes higher.

Although the piezoelectric ceramics disclosed in the patent article 1 have attained an improvement of an electromechanical coupling coefficient "kr", it is insufficient in the Qₘₐₓ. Thus, it is hard to say that piezoelectric characteristics able to be used as a piezoelectric substance of a resonator are provided. The piezoelectric ceramics disclosed in the patent article 2 have a large Qₘₐₓ, but the Qₘₐₓ is that in the fundamental wave mode in thickness vertical vibration. Therefore, sufficient piezoelectric characteristics are not obtained as piezoelectric ceramics using third harmonics of thickness vertical vibration and those using thickness-shear vibration.

In the patent article 3, an evaluation of Qₘₐₓ in the third harmonic mode is made on thickness vertical vibration of piezoelectric ceramics according to the invention, but the evaluation is made at a relatively low frequency of 10 MHz or so. Generally, it is liable that the higher the measurement frequency becomes, the smaller the Qₘₐₓ of piezoelectric ceramics becomes. Therefore, it is difficult for the piezoelectric ceramics described in the patent article 3 to respond to recent demands for attaining a higher frequency.

Specifically, the patent article 3 discloses piezoelectric ceramics including Ca_{0.9}La_{0.1}Bi₄Ti₄O₁₅ type crystal or Sr_{0.9}La_{0.1}Bi₄Ti₄O₁₅ type crystal as a main component and MnO as a subcomponent thereof. However, sufficient Qₘₐₓ is not obtained by the piezoelectric ceramics even at a relatively low frequency of 10 MHz or so. Therefore, it is considered that when the measurement frequency becomes still higher, the Qₘₐₓ furthermore declines.

The patent article 3 also discloses piezoelectric ceramics utilizing thickness-shear vibration in addition to the piezoelectric ceramics utilizing thickness vertical vibration as explained above. According to this article, piezoelectric ceramics having relatively high Qₘₐₓ is obtained in a fundamental wave mode of thickness-shear vibration. However, even such piezoelectric ceramics utilizing thickness-shear vibration are also demanded to have an improved Qₘₐₓ in the fundamental wave mode of thickness-shear vibration in terms of an improvement of resonator performance.

Note that the patent article 3 describes ceramic particles (crystal grains) having a spindle or needle shape. And, an average particle diameter (average crystal diameter) in the long axis direction is disclosed. However, the average particle diameter considering only the long axis direction indicates lengths of the particles only in one direction and a shape of the actual ceramic particles is not considered.

Furthermore, a vibration mode of piezoelectric substance changes in accordance with an oscillation frequency and, logically, the thinner a thickness of the piezoelectric substance is, the higher the resonant frequency becomes. Accordingly, to respond to a high frequency, it is useful to make the piezoelectric substance a thin layer, however, there is a physical limitation in making a piezoelectric substance thinner. Thus, in piezoelectric ceramics utilizing thickness vertical vibration, a method of oscillating at a targeted frequency or lower and utilizing a higher harmonic thereof, such as a third harmonics, is used so as to deal with a high frequency. Moreover, to deal with a higher frequency, excellent piezoelectric characteristics, such as a high Qₘₐₓ, are demanded in the third harmonic mode of thickness vertical vibration at a higher frequency.
[Patent Article 1] The Japanese Unexamined Patent Publication No. 2000-159574
[Patent Article 2] The Japanese Unexamined Patent Publication No. 2000-143340
[Patent Article 3] The Japanese Unexamined Patent Publication No. 2001-192267

### SUMMARY OF THE INVENTION

### PROBLEM TO BE SOLVED BY THE INVENTION

An object of the present invention is to provide piezoelectric ceramics having a large Qₘₐₓ in a third harmonic mode of thickness vertical vibration in a relatively high frequency band (for example, 16 to 65 MHz) and a piezoelectric element, such as a piezoelectric ceramic resonator having the piezoelectric ceramics as a piezoelectric substance thereof.

Another object of the present invention is to provide piezoelectric ceramics having a large Qₘₐₓ in the fundamental wave mode (for example, 4 to 12 MHz, particularly at 8 MHz) of thickness-shear vibration and a piezoelectric element, such as a piezoelectric ceramic resonator having the piezoelectric ceramics as a piezoelectric substance thereof.

### MEANS FOR SOLVING THE PROBLEM

The present inventors have conducted experiments on an assumption that a particle diameter of ceramic particles composing the piezoelectric ceramics and the Qₘₐₓ are in correlation in some ways, found that a Qₘₐₓ value of the piezoelectric ceramics can be made large even when measuring at a high frequency as well as that in the case of measuring at a low frequency by controlling an average particle diameter of the ceramic particles after firing to be in a predetermined range, and completed the present invention.

To attain the above object, according to a first aspect of the present invention, there is provided a piezoelectric ceramics having ceramic particles, wherein:
the ceramic particles comprises
   bismuth layer compound containing at least Sr, Ln (note that Ln is a lanthanoid element), Bi, Ti and O and including M^{II}Bi₄Ti₄O₁₅ type crystal (M^{II} is an element composed of Sr and Ln) as a main component, and
   an oxide of Mn as a subcomponent; and
an average particle diameter by the code length measuring method is 0.8 to 4.7 µm.

In the piezoelectric ceramics according to the first aspect, preferably, the M^{II}Bi₄Ti₄O₁₅ type crystal (M^{II} is an element composed of Sr and Ln) is expressed by a composition formula (Sr_{α}Ln_{β})Bi_{γ}Ti₄O₁₅, wherein "α" satisfies α = 1-β, "β" satisfies 0.01 ≤ β ≤ 0.50 and "γ" satisfies 3.80 ≤ γ ≤ 4.50.

In the piezoelectric ceramics according to the first aspect, preferably, a content of an oxide of the Mn is 0.1 to 1.0 wt% in terms of MnO.

The piezoelectric ceramics according to the first aspect is preferably produced by a firing step controlled to be under the condition below.
The firing temperature is preferably 1050 to 1250°C, and more preferably 1100 to 1200°C.
The firing time is preferably 1 to 8 hours.
When the firing temperature and firing time change, it is liable that an average particle diameter of ceramic particles composing the piezoelectric ceramics also changes. Therefore, in the first aspect, firing is performed under the above condition in terms of controlling the average particle diameter of the ceramic particles.

A piezoelectric element according to the first aspect comprises a piezoelectric substance comprising the piezoelectric ceramics as set forth in any one of the above.

In the piezoelectric element according to the first aspect, it is possible that the maximum value Qₘₐₓ of "Q" (Q = |X|/R, wherein "X" is reactance and "R" is resistance) between a resonant frequency and antiresonant frequency with respect to the third harmonic wave of thickness vertical vibration in a relatively high frequency range of, for example, 16 to 65 MHz can be large.

In the piezoelectric element according to the first aspect, the Qₘₐₓ at 16 to 25 MHz or so can be preferably 8 or larger, the Qₘₐₓ at 25 to 40 MHz or so can be preferably 7 or larger, the Qₘₐₓ in 45 to 55 MHz or so can be preferably 6.5 or larger, and the Qₘₐₓ in 55 to 65 MHz or so can be preferably 6 or larger.

Particularly, in the piezoelectric element according to the first aspect, preferably, a maximum value Qₘₐₓ of "Q" between a resonant frequency and an antiresonant frequency with respect to a third harmonic wave of thickness vertical vibration at 24 MHz is preferably 8 or larger, and more preferably 9 or larger.

As use objects in the third harmonic mode of thickness vertical vibration at 24 MHz, a HDD control IC and printer control IC, etc. may be mentioned, and the piezoelectric element according to the first aspect of the present invention can be preferably used for these use objects. When using in the use objects, preferably, a piezoelectric element having a Qₘₐₓ in the third harmonic mode of thickness vertical vibration at 24 MHz of 8 or larger is required.

According to the second aspect of the present invention, there is provided a piezoelectric ceramics having ceramic particles, wherein:
the ceramic particles comprises
   bismuth layer compound containing at least Ca, Ln (note that Ln is a lanthanoid element), Bi, Ti and O and including M^{II}Bi₄Ti₄O₁₅ type crystal (M^{II} is an element composed of Ca and Ln) as a main component, and
   an oxide of Mn as a subcomponent; and
an average particle diameter by the code length measuring method is 1.0 to 4.5 µm.

In the piezoelectric ceramics according to the second aspect, preferably, the M^{II}Bi₄Ti₄O₁₅ type crystal (M^{II} is an element composed of Ca and Ln) is expressed by a composition formula (Ca_{1-β}Ln_{β})Bi_{γ}Ti₄O₁₅, and "β" satisfies 0.01 ≤ β ≤ 0.5 and "γ" satisfies 3.80 ≤ γ ≤ 4.20.

In the piezoelectric ceramics according to the second aspect, preferably, a content of an oxide of the Mn is 0.1 to 1.0 wt% in terms of MnO.

The piezoelectric ceramics according to the second aspect is preferably produced by a firing step controlled to be under the condition below.
The firing temperature is preferably 1100 to 1250°C, and more preferably 1150 to 1200°C.
The firing time is preferably 1 to 3 hours.
When the firing temperature and firing time change, it is liable that an average particle diameter of ceramic particles composing the piezoelectric ceramics also changes. Therefore, in the second aspect, firing is performed under the above condition in terms of controlling the average particle diameter of the ceramic particles.

The piezoelectric element according to the second aspect comprises a piezoelectric substance formed by the piezoelectric ceramics as set forth in any one of the above.

In the piezoelectric element according to the second aspect, it is possible that the maximum value Qₘₐₓ of "Q" (Q = |X|/R, wherein "X" is reactance and "R" is resistance) between a resonant frequency and antiresonant frequency with respect to the third harmonic wave of thickness vertical vibration in a relatively high frequency range of, for example, 16 to 65 MHz can be large.

In the piezoelectric element according to the second aspect, the Qₘₐₓ at 16 to 25 MHz or so can be preferably 8 or larger, the Qₘₐₓ at 25 to 40 MHz or so can be preferably 7 or larger, the Qₘₐₓ in 45 to 55 MHz or so can be preferably 6.5 or larger, and the Qₘₐₓ in 55 to 65 MHz or so can be preferably 6 or larger.

Particularly, in the piezoelectric element according to the second aspect, a maximum value Qₘₐₓ of "Q" between a resonant frequency and an antiresonant frequency with respect to a third harmonic wave of thickness vertical vibration at 60 MHz is preferably 6 or larger, and more preferably 6.2 or larger.

As use objects in the third harmonic mode of thickness vertical vibration at 60 MHz, a microcomputer control in a personal computer, particularly in a hard disk, and microcomputer control for a printer, etc. may be mentioned, and the piezoelectric element according to the second aspect of the present invention can be preferably used for these use objects. When using in the use objects, preferably, a piezoelectric element having a Qₘₐₓ in the third harmonic mode of thickness vertical vibration at 60 MHz of 6 or larger is required.

According to the third aspect of the present invention, there is provided a piezoelectric ceramics having ceramic particles, wherein:
the ceramic particles comprises
   bismuth layer compound containing at least Ba, Sr, Ln (note that Ln is a lanthanoid element), Bi, Ti and O and including M^{II}Bi₄Ti₄O₁₅ type crystal (M^{II} is an element composed of Ba, Sr and Ln) as a main component, and
   an oxide of Mn and an oxide of Ge as a subcomponent; and
an average particle diameter by the code length measuring method is 0.4 to 3.2 µm.

In the piezoelectric ceramics according to the third aspect, preferably, the M^{II}Bi₄Ti₄O₁₅ type crystal (M^{II} is an element composed of Ba, Sr and Ln) is expressed by a composition formula (Ba_{1-α-β}Sr_{α}Ln_{β})Bi_{γ}Ti₄O₁₅, and
"α" satisfies 0.1 ≤ α ≤ 0.6, "β" satisfies 0.05 ≤ β ≤ 0.5 and "γ" satisfies 3.90 ≤ γ ≤ 4.30 in the composition formula.

In the piezoelectric ceramics according to the third aspect, preferably, a content of an oxide of the Mn is 0.1 to 1.0 wt% in terms of MnO, and
a content of an oxide of the Ge is 0.05 to 0.5 wt% in terms of GeO₂.

The piezoelectric ceramics according to the third aspect is preferably produced by a firing step controlled to be under the condition below.
The firing temperature is preferably 1000 to 1200°C, and more preferably 1050 to 1150°C.
The firing time is preferably 1 to 8 hours.
When the firing temperature and firing time change, it is liable that an average particle diameter of ceramic particles composing the piezoelectric ceramics also changes. Therefore, in the third aspect, firing is performed under the above condition in terms of controlling the average particle diameter of the ceramic particles.

The piezoelectric element according to the third aspect comprises a piezoelectric substance formed by the piezoelectric ceramics as set forth in any one of the above.

In the piezoelectric element according to the third aspect, it is possible that the maximum value Qₘₐₓ of "Q" (Q = |X|/R, wherein "X" is reactance and "R" is resistance) between a resonant frequency and antiresonant frequency with respect to the fundamental wave of thickness-shear vibration in a relatively high frequency range of, for example, 4 to 12 MHz can be large.

In the piezoelectric element according to the third aspect, the Qₘₐₓ at 4 to 6 MHz or so can be preferably 17 or larger, and the Qₘₐₓ in 10 to 12 MHz or so can be preferably 23 or larger.

Particularly, in the piezoelectric element according to the third aspect, a maximum value Qₘₐₓ of "Q" between a resonant frequency and an antiresonant frequency with respect to the fundamental wave of thickness-shear vibration at 8 MHz is preferably 23 or larger, more preferably 25 or larger, and particularly preferably 27 or larger.

As use objects in the fundamental wave of thickness-shear vibration at 8 MHz, IC control to be installed in a vehicle and an IC for controlling AV apparatuses, etc. may be mentioned, and the piezoelectric element according to the third aspect of the present invention can be preferably used for these use objects. When using in the use objects, preferably, a piezoelectric element having a Qₘₐₓ in the fundamental wave of thickness-shear vibration at 8 MHz of 23 or larger is required.

In the first, second and third aspects of the present invention, an average particle diameter of ceramic particles is measured by the code length measuring method for measuring an average particle diameter on an assumption that a shape of the ceramic particles is sphere. In the code length measuring method, an actual particle shape of the ceramic particles is reflected to the average particle diameter because the average particle diameter is measured on an assumption that the ceramic particles are sphere.

The present inventors found that there was a certain correlation between an average particle diameter measured by the code length measuring method and a Qₘₐₓ from experiments, namely, they found that the Qₘₐₓ became small when an average particle diameter of ceramic particles after firing was too small or too large. On the other hand, a certain correlation as above was not found between the average particle diameter only considering in the long axis direction and a Qₘₐₓ as described in the patent article 3. The reason thereof is not certain, but it is considered that a value of the average particle diameter does not reflect an actual particle shape of the ceramic particles in the average particle diameter only considering the long axis direction as in the patent article 3 (The Japanese Unexamined Patent Publication No. 2001-192267).

In the first, second and third aspects of the present invention, it is sufficient if the M^{II}Bi₄Ti₄O₁₅ type crystal has a composition close to M^{II}Bi₄Ti₄O₁₅ and the composition may be deviated from that. For example, a ratio of Bi to Ti may be a little deviated from the stoichiometric composition, and a part of respective elements considered to mainly substitute the M^{II} site may substitute other side. Note that, in the present invention, the respective elements considered to substitute the M^{II} site are Sr and Ln in the first aspect, Ca and Ln in the second aspect, and Ba, Sr and Ln in the third aspect.

Also, the piezoelectric ceramics of the present invention include as a main component a bismuth layer compound comprising M^{II}Bi₄Ti₄O₁₅ type crystal and, preferably, it is substantially composed of the crystal, but it does not has to be completely homogenized and may include, for example, a hetero-phase.

In the present invention, Qₘₐₓ is tanθₘₐₓ when assuming that the maximum value of a phase angle is θₘₐₓ. Namely, when assuming that "X" is reactance and "R" is resistance, it is a maximum value of Q(=|X|/R) between a resonant frequency and antiresonant frequency. The larger the Qₘₐₓ is, the more stable the oscillation becomes and oscillation at a low voltage becomes possible.

The piezoelectric element according to the first, second and third aspects of the present invention is not particularly limited, and a piezoelectric ceramic resonator, a filter, a sensor and an actuator, etc. may be mentioned.

### EFFECTS OF THE INVENTION

As described in the patent article 3, on a premise of being used in a relatively low frequency band, in the case where an average particle diameter of fired ceramic particles composing the piezoelectric ceramics is adjusted only in the long axis direction, a sufficiently large Qₘₐₓ value cannot be obtained in many cases when it is used in a high frequency band as they are. Particularly, in the patent article 3, the piezoelectric ceramics including a bismuth layer compound including Sr and a Mn compound has a low Qₘₐₓ value of 7.6 at a low frequency of 10 MHz or so.

On the other hand, the piezoelectric ceramics according to the first aspect of the present invention have a specific composition of including a bismuth layer compound including Sr and a Mn compound and include ceramic particles controlled to have an average particle diameter in a predetermined range. Therefore, a Qₘₐₓ value of the piezoelectric ceramics measured at the third harmonic mode of thickness vertical vibration at a relatively high frequency band of, for example, 16 to 65 MHz can be made large. Specifically, for example, a Qₘₐₓ value at 24 MHz can be preferably 8 or larger. As a result, use in a high frequency band desired in recent years can be expected.

The piezoelectric element according to the first aspect includes a piezoelectric substance formed by the piezoelectric ceramics according to the first aspect explained above. Therefore, a Qₘₐₓ value measured at the third harmonic mode of thickness vertical vibration in a relatively high frequency band is large and it can be used in a high frequency band.

Also, the piezoelectric ceramics according to a second aspect of the present invention have a specific composition of including a bismuth layer compound including Ca and a Mn compound and include ceramic particles controlled to have an average particle diameter in a predetermined range. Therefore, a Qₘₐₓ value of the piezoelectric ceramics measured at the third harmonic mode of thickness vertical vibration at a relatively high frequency band of, for example, 16 to 65 MHz can be made large. Specifically, for example, a Qₘₐₓ value at 60 MHz can be preferably 6 or larger. As a result, use in a high frequency band desired in recent years can be expected.

The piezoelectric element according to the second aspect has a piezoelectric substance formed by the piezoelectric ceramics according to the second aspect. Therefore, a Qₘₐₓ value measured at the third harmonic mode of thickness vertical vibration at a relatively high frequency band is large and it can be used in a high frequency band.

Furthermore, the piezoelectric ceramics according to the third aspect have a specific composition including a bismuth layer compound containing Ba, Sr and compounds of Mn and Ge and include ceramic particles controlled to have an average particle diameter in a predetermined range. Therefore, a Qₘₐₓ value of the piezoelectric ceramics measured at the fundamental wave mode of thickness-shear vibration in a frequency band of, for example, 4 to 12 MHz can be made large. Specifically, for example, a Qₘₐₓ value in the fundamental wave mode of thickness-shear vibration at 8 MHz can be preferably 23 or larger, more preferably 25 or larger, and particularly preferably 27 or larger.

### BRIEF DESCRIPTION OF DRAWINGS

FIG. 1 is a perspective view of a piezoelectric ceramic resonator according to an embodiment of the present invention.
FIG. 2 is a sectional view of a piezoelectric ceramic resonator according to an embodiment of the present invention.
FIG. 3 is a view for explaining a measuring method of an average particle diameter of ceramic particles in the present invention.
FIG. 4 is a SEM picture of a piezoelectric layer of the piezoelectric ceramics of an example 1-1 in examples of the present invention.
FIG. 5 is a graph showing a relationship of an average particle diameter of ceramic particles and a Qₘₐₓ in the example 1-1 in the examples of the present invention.
FIG. 6 is a graph showing a relationship of an average particle diameter of ceramic particles and a Qₘₐₓ in an example 1-2 in the examples of the present invention.
FIG. 7 is a graph showing a relationship of an average particle diameter of ceramic particles and a Qₘₐₓ in an example 1-3 in the examples of the present invention.
FIG. 8 is a graph showing a relationship of an average particle diameter of ceramic particles and a Qₘₐₓ in an example 1-4 in the examples of the present invention.
FIG. 9 is a SEM picture of a piezoelectric layer of the piezoelectric ceramics of an example 2-1 in the examples of the present invention.
FIG. 10 is a graph showing a relationship of an average particle diameter of ceramic particles and a Qₘₐₓ in an example 2-1 in the examples of the present invention.
FIG. 11 is a graph showing a relationship of an average particle diameter of ceramic particles and a Qₘₐₓ in an example 2-2 in the examples of the present invention.
FIG. 12 is a graph showing a relationship of an average particle diameter of ceramic particles and a Qₘₐₓ in an example 2-3 in the examples of the present invention.
FIG. 13 is a graph showing a relationship of an average particle diameter of ceramic particles and a Qₘₐₓ in an example 2-4 in the examples of the present invention.
FIG. 14 is a SEM picture of a piezoelectric layer of piezoelectric ceramics in an example 3-1 in the examples of the present invention.
FIG. 15 is a graph showing a relationship of an average particle diameter of ceramic particles and a Qₘₐₓ in an example 3-1 in the examples of the present invention.
FIG. 16 is a graph showing a relationship of an average particle diameter of ceramic particles and a Qₘₐₓ in an example 3-2 in the examples of the present invention.
FIG. 17 is a graph showing a relationship of an average particle diameter of ceramic particles and a Qₘₐₓ in an example 3-3 in the examples of the present invention.
FIG. 18 is a graph showing a relationship of an average particle diameter of ceramic particles and a Qₘₐₓ in an example 3-4 in the examples of the present invention.
FIG. 19 is a graph showing a relationship of an average particle diameter of ceramic particles and a Qₘₐₓ in an example 3-5 in the examples of the present invention.

### DESCRIPTION OF THE PREFERRED EMBODIMENT

Below, the present invention will be explained based on embodiments shown in the drawings.
In the present embodiments, a piezoelectric ceramic resonator including piezoelectric ceramics will be explained as an example of a piezoelectric element.

### First Embodiment

In the first embodiment, piezoelectric ceramics include at least Sr, Ln, Bi, Ti and O, a bismuth layer compound including M^{II}Bi₄Ti₄O₁₅ type crystal (M^{II} is an element composed of Sr and Ln) as a main component, an oxide of Mn as a subcomponent, and ceramic particles controlled to have an average particle diameter in a predetermined range.

Piezoelectric ceramics and piezoelectric ceramic resonator of the first embodiment can obtain a larger Qₘₐₓ of "Q" between a resonant frequency and an antiresonant frequency with respect to a third harmonic wave of thickness vertical vibration at 16 to 65 MHz, particularly at 24 MHz.

Below, the first embodiment of the present invention will be explained.

### Piezoelectric Ceramic Resonator

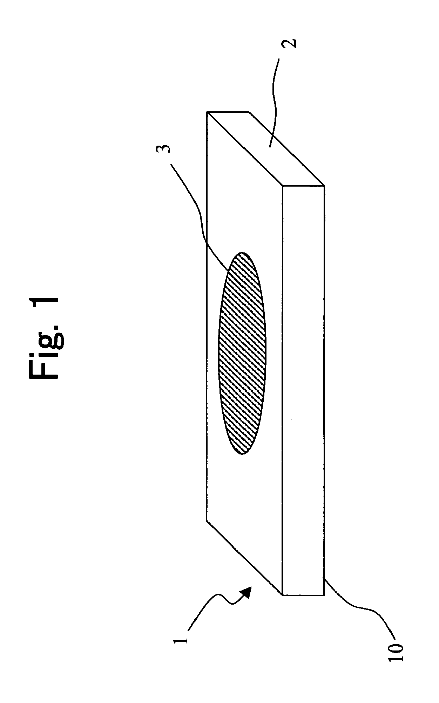

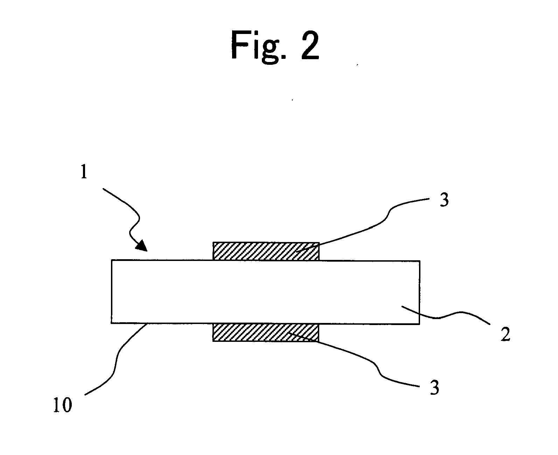

As shown in FIG. 1 and FIG. 2, the piezoelectric ceramic resonator 1 according to the first embodiment includes a resonator element body 10 having the configuration that the piezoelectric substance layer 2 is sandwiched by two vibrating electrodes 3. The vibrating electrodes 3 are formed at the center of upper and lower surfaces of the piezoelectric substance layer 2. The shape of the resonator element body 10 is not particularly limited, but is normally rectangular parallelepiped. Also, the size is not particularly limited and may be a size in accordance with the use object, but is normally 1.0 to 4.0 mm in length × 0.5 to 4.0 mm in width × 50 to 300 µm in height or so.

The piezoelectric substance layer 2 includes the piezoelectric ceramics according to the first aspect of the present invention.
The piezoelectric ceramics according to the first aspect includes ceramic particles.
The ceramic particles include a main component including a bismuth layer compound and a subcomponent including at least an oxide of Mn.

The above bismuth layer compound has a layered configuration that a pseudo-perovskite structure layer is sandwiched by a pair of layers of Bi and O.
In the first embodiment, the bismuth layer compound contains at least Sr, Ln (note that Ln is lanthanoid element), Bi, Ti and O, and includes M^{II}Bi₄Ti₄O₁₅ type crystal. In the first embodiment, M^{II} in the M^{II}Bi₄Ti₄O₁₅ type crystal is an element composed of Sr and Ln, and the M^{II}Bi₄Ti₄O₁₅ type crystal is preferably expressed by a composition formula of (Sr_{α} Ln_{β})Bi_{γ} Ti₄O₁₅. Note that, in the present invention, an oxygen (O) amount may be a little deviated from the above stoichiometric composition.

In the above composition formula, "α" indicates the number of atoms of Sr. It is preferable that α = 1-β. Namely, in the first embodiment, an amount of Sr may be determined in accordance with an amount of Ln (a value of β) in the M^{II} site.

Preferably, "β" in the composition formula satisfies 0.01 ≤ β ≤ 0.50, more preferably 0.05 ≤ β ≤ 0.30. The "β" indicates the number of atoms of Ln. Ln has an effect of improving Qₘₐₓ. Here, Ln indicates a lanthanoid element, and the lanthanoid element is La, Ce, Pr, Nd, Pm, Sm, Eu, Gd, Tb, Dy, Ho, Er, Tm, Yb and Lu. Among them, particularly at least one kind of element selected from La, Pr, Ho, Gd, Sm and Er is preferable. When the β value is too small, the Qₘₐₓ tends to decline, while when too large, the Qₘₐₓ also tends to decline. Note that, in the first embodiment, the Qₘₐₓ means a value in the third harmonic mode of thickness vertical vibration at 24 MHz.

In the above composition formula, "γ" preferably satisfies 3.80 ≤ γ ≤ 4.50, and more preferably 3.90 ≤ γ ≤ 4.20. The "γ" indicates the number of atoms of Bi. When the "γ" is in the above ranges, a mechanical quality coefficient (Qₘ) can be improved. When the γ value is too small, the sinterability declines and the Qₘₐₓ tends to decline, while when too large, the electric resistance declines, so that the polarization becomes difficult and the Qₘₐₓ tends to decline.

A content of Mn oxide is preferably 0.1 to 1.0 wt%, and more preferably 0.3 to 0.7 wt% in terms of MnO. When the content of Mn oxide is too small, the Qₘₐₓ tends to decline, while when too large, it is liable that the insulation resistance declines and polarization becomes difficult.

Also, the ceramic particles may also include as impurities or a trace of additives compounds other than the above, for example, oxides of elements of Ca, Sn, Mo, W, Y, Zn, Sb, Si, Nb and Ta. Note that a content in that case is preferably 0.01 wt% or smaller with respect to the entire piezoelectric ceramics in terms of oxides of respective elements.

A characteristic of the first embodiment is that the ceramic particles have an average particle diameter of 0.8 to 4.7 µm. When the average particle diameter of the ceramic particles is in the above range, the Qₘₐₓ of the piezoelectric ceramics in the third harmonic mode of thickness vertical vibration in a relatively high frequency band (for example, 16 to 65 MHz) can be made large. The present inventors have found that the Qₘₐₓ tends to decline when the average particle diameter of the ceramic particles is too small or too large. According to the knowledge of the present inventors, this tendency becomes notable in the case of a relatively high measurement frequency (for example, 16 to 65 MHz) comparing with the case of a relatively low measurement frequency (for example, 10 MHz).

Note that the reason why the Qₘₐₓ in the third harmonic mode of thickness vertical vibration can be made large by setting an average particle diameter of the ceramic particles in the above range is not certain, but the reason below may be considered.
Namely, it is considered that when the average particle diameter of the ceramic particles is in the above predetermined range, it becomes possible to control a hole volume per one ceramic particle in the piezoelectric ceramics sintered body and unify a hole distribution in the sintered body.

The lower limit of the average particle diameter is 0.8 µm or larger, preferably 0.9 µm or larger, furthermore preferably 1.0 µm or larger, particularly preferably 1.20 µm or larger, and most preferably 1.50 µm or larger. Also, the upper limit of the average particle diameter is 4.7 µm or smaller, preferably 4.6 µm or smaller, more preferably 4.0 µm or smaller, furthermore preferably 3.7 µm or smaller, particularly preferably 3.50 µm or smaller, and most preferably 3.30 µm or smaller.

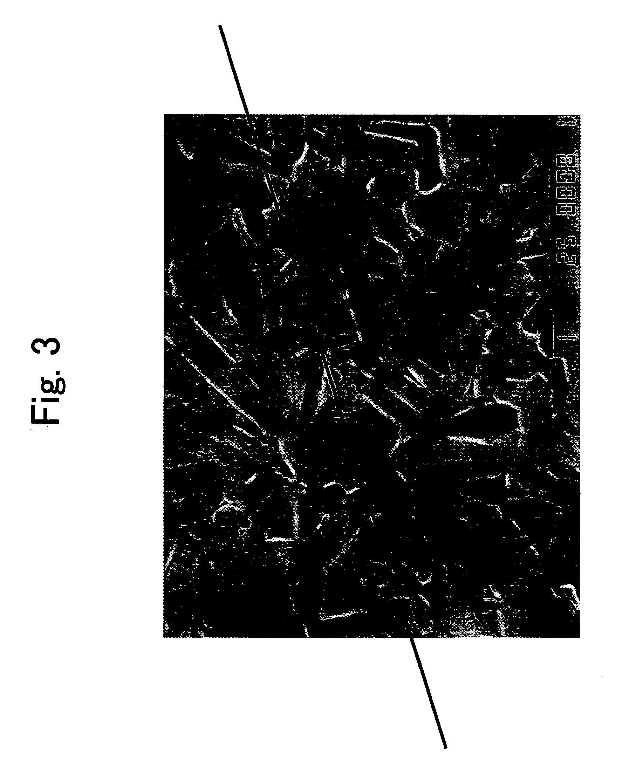

Note that an average particle diameter of the ceramic particles in the present embodiment is measured by the code length measuring method explained below. In the code length measuring method, the average particle diameter is measured on an assumption that a shape of the ceramic particle is sphere. FIG. 3 is a view for explaining the measuring method of the average particle diameter of the ceramic particles in the present invention.

First, the piezoelectric substance layer 2 composed of the piezoelectric ceramics is cut, and a SEM picture of the cut surface is taken by a scanning electronic microscope (SEM). Next, a straight line is drawn on the obtained SEM picture as shown in FIG. 3, and the number of particles (the number of particles: n) existing on the straight line and a distance (a code length: L3) that the straight line passes through each of the particles existing on the straight line are obtained. Then, by obtaining a total (EL3) of code lengths (L3) of the respective particles and dividing the result (EL3) by the number of particles (n), an average code length (L3₍ₐᵥₑ₎: L3₍ₐᵥₑ₎ = EL3/n) is obtained. Next, by multiplying the obtained average code length (L3₍ₐᵥₑ₎) with a constant "k" (k = 1.5), an average particle diameter (G₍ₐᵥₑ₎: G₍ₐᵥₑ₎ = L3₍ₐᵥₑ₎ × 1.5) is obtained. Here, the constant "k" (=1.5) is a constant to be multiplied on an assumption that the shape of the ceramic particles is sphere. Note that, in FIG. 3, only one straight line is drawn, but a plurality of straight lines are normally drawn on one SEM picture and particle diameters are measured on particles existing on the lines when measuring an average particle diameter.

Also, as is obvious from FIG. 3, a direction of the straight line drawn on the SEM picture does not always match with a direction of a long axis of the ceramic particles, and the straight line and ceramic particles normally cross at arbitrary directions. Therefore, in the measuring method of a code length, particle diameters are measured in the arbitrary direction on respective particles, consequently, an average particle diameter reflecting actual particle shapes of the ceramic particles is obtained.

In the first embodiment, the ceramic particles are composed to have the above predetermined composition and made to have an average particle diameter of 0.8 to 4.7 µm, so that it is possible to obtain piezoelectric ceramics and a piezoelectric ceramic resonator having a large Qₘₐₓ in the third harmonic mode of thickness vertical vibration. In the first embodiment, since piezoelectric ceramics including ceramic particles as above are used, the Qₘₐₓ in the third harmonic mode of thickness vertical vibration at 24 MHz can be preferably 8 or larger, and more preferably 9 or larger.

A thickness of the piezoelectric substance layer 2 is not particularly limited, but is normally 50 to 300 µm or so. Also, in the first embodiment, a polarization direction of the piezoelectric substance layer 2 is the same as a thickness direction of the piezoelectric substance layer 2.

A conductive material included in the vibrating electrodes 3 is not particularly limited and, for example, Ag, etc. may be used. Also, a shape of the vibrating electrodes 3 is not particularly limited, but it is preferably a circular shape having a diameter of 0.5 to 3.0 mm and the thickness is normally 0.5 to 5 µm or so in the present embodiment.

### Production Method of Piezoelectric Ceramic Resonator

The piezoelectric ceramic resonator 1 of the first embodiment is produced by granulating piezoelectric ceramics material powder, performing press molding and firing to produce a piezoelectric substance layer, performing polarization processing on the piezoelectric substance layer and forming a vibrating electrode by a vacuum evaporation method or sputtering method. Below, the production method will be explained specifically.

First, main component materials and subcomponent materials composing piezoelectric ceramic material powder are prepared.
As the main component materials, oxides of respective elements composing the bismuth layer compound explained above and/or compounds which become these oxides after firing may be used. As the subcomponent materials, oxides of respective subcomponents explained above and/or compounds which become these oxides after firing may be used. Also, as the compounds which become oxides after firing, for example, carbonates, hydroxides, oxalates and nitrites, may be mentioned. An average particle diameter of the main component materials and subcomponent materials is preferably 1.0 to 5.0 µm.

Next, the main component materials and subcomponent materials are wet mixed by a ball mill, etc.

Next, material powder subjected to wet mixing is temporarily molded in accordance with need and calcined to obtain a calcined material. In the first embodiment, the calcined material contains a bismuth layer compound including M^{II}Bi₄Ti₄O₁₅ type crystal (M^{II} is an element composed of Sr and Ln), an oxide of Mn and/or a compound which becomes an oxide of Mn after firing.

A condition of the calcining is a calcining temperature of preferably 700 to 1000°C, more preferably 750 to 850°C, and calcining time of preferably 1 to 3 hours or so. When the calcining temperature is too low, it is liable that the chemical reaction becomes insufficient, while when too high, the temporary mold starts to be sintered, and pulverization after that tends to become difficult. The calcining may be performed in the air, in an atmosphere having a higher oxygen partial pressure than that of the air, or in a pure oxygen atmosphere.

Next, the calcined material obtained by the calcining is made to be slurry, finely pulverized, then, the slurry is dried, so that piezoelectric ceramic material powder is obtained. The fine pulverization can be performed, for example, by wet pulverization by a ball mill, etc. At this time, it is preferable to use as a solvent of the slurry water, ethanol, other alcohol or a mixed solvent of water and ethanol.

Preferably, the fine pulverization above is performed, so that the 50% diameter (D50 diameter) of piezoelectric ceramic material powder to be obtained in a cumulative number-size distribution becomes preferably 0.35 to 1.90 µm, and more preferably 0.40 to 1.83 µm. Note that the D50 diameter can be measured, for example, by a laser light diffraction method, etc.

Next, the obtained piezoelectric ceramic material powder obtained as above is added with a binder in accordance with need, granulated, then, press molded, so as to obtain a mold. As the binder, polyvinyl alcohol, polyvinyl alcohol added with dispersant and ethyl cellulose and other generally used organic binder may be mentioned. Also, weight at the press molding may be, for example, 100 to 400 MPa.

Next, binder removal processing is performed on the mold. The binder removal processing is preferably performed at 300 to 700°C for 0.5 to 5 hours or so. The binder removal processing may be performed in the air, in an atmosphere having a higher oxygen partial pressure than that of the air, or in a pure oxygen atmosphere.

After performing the binder removal processing, firing is performed to obtain a sintered body of piezoelectric ceramics. The firing is preferably performed under the condition below. Namely, the firing temperature is preferably 1050 to 1250°C, and more preferably 1100 to 1200°C. Also, the firing time is preferably 1 to 8 hours or so. When the firing temperature and firing time change, it is liable that an average particle diameter of the ceramic particles composing the piezoelectric ceramics also changes, so that the firing is preferably performed under the above condition in terms of controlling the average particle diameter of the ceramic particles. In the present embodiment, by controlling the firing condition as above, there are advantages that the average particle diameter of the ceramic particles is controlled, fine sintered body can be obtained, and the Qₘₐₓ can be improved.

It is liable that sintering becomes insufficient when the firing temperature is too low, and a function as piezoelectric ceramics tends to becomes insufficient. When the firing temperature is too high, Bi evaporates, deviation of the composition is caused and an average particle diameter of the ceramic particles becomes too large, so that the Qₘₐₓ tends to decline. When the firing time is too short, the sintering tends to become insufficient, while when too long, the average particle diameter becomes too large, Bi evaporates and holes become large, so that the Qₘₐₓ tends to decline. Note that firing may be performed in the air, in an atmosphere having a higher oxygen partial pressure than that of the air, or in a pure oxygen atmosphere.

Note that the binder removal step and firing step may be performed successively or separately.

Next, a sintered body of the piezoelectric ceramics obtained by the firing is cut to be a thin plate to obtain a sintered thin plate and surface processing by lapping is performed. Cutting of the sintered body may be performed by using a cutting machine, such as a cutter, slicer, and dicing saw.

Next, on both surfaces of the thin plate sintered body, temporary electrodes for polarization processing are formed. A conductive material for composing the temporary electrodes is not particularly limited, but Cu is preferable because it can be easily removed by etching processing by a ferric chloride solution. Formation of the temporary electrodes is preferably performed by using the vacuum evaporation method and sputtering.

Next, polarization processing is performed on the thin plate sintered body having temporary electrodes formed for polarization processing. A condition of the polarization processing may be suitably determined in accordance with a composition of the piezoelectric ceramics, and normally the polarization temperature may be 150 to 300°C, the polarization time may be 1 to 30 minutes and a polarization electric field may be 1.1 times the coercive electric field of the sintered body or higher. Also, in the first embodiment, the polarization processing is performed, so that the polarization direction of the sintered body becomes the same as the thickness direction of the piezoelectric substance layer 2.

Next, the temporary electrodes are removed by etching processing, etc. from the sintered body subjected to polarization processing, the result is cut to be a desired element shape, then, vibrating electrodes 3 are formed. A conductive material composing the vibrating electrodes 3 is not particularly limited and Ag, etc. may be used. Formation of the vibrating electrodes may be performed by using the vacuum evaporation method and sputtering.
As explained above, the piezoelectric ceramic resonator of the present embodiment is produced.

According to the first embodiment, in the piezoelectric ceramics and the piezoelectric ceramic resonator, it is possible to attain the Qₘₐₓ in the third harmonic mode of thickness vertical vibration at 24 MHz of preferably 8 or larger, and more preferably 9 or larger. The reason why the measurement frequency is set to 24 MHz is to deal with an HDD control IC and printer control IC, etc. In the case of being used for the use objects, preferably, the piezoelectric ceramics having the Qₘₐₓ in the third harmonic mode of thickness vertical vibration at 24 KHz of 8 or larger is demanded.

Note that, in the first embodiment, a Qₘₐₓ in the third harmonic mode of thickness vertical vibration at 24 MHz was explained, however, the piezoelectric ceramic resonator of the first embodiment has a large Qₘₐₓ also in a frequency band of 16 to 65 MHz or so and may be also suitably used in that frequency band. According to the first embodiment, for example, the Qₘₐₓ at 16 to 25 MHz or so can be 8 or larger, the Qₘₐₓ at 25 to 40 MHz or so (particularly 33 MHz) can be 7 or larger, the Qₘₐₓ in 45 to 55 MHz or so (particularly 50 MHz) may be preferably 6.5 or larger, and the Qₘₐₓ in 55 to 65 MHz or so (particularly 60 MHz) may be preferably 6 or larger.

### Second Embodiment

In the second embodiment, piezoelectric ceramics include at least Ca, Ln, Bi, Ti and O, a bismuth layer compound including M^{II}Bi₄Ti₄O₁₅ type crystal (M^{II} is an element composed of Ca and Ln) as the main component, an oxide of Mn as the subcomponent, and ceramic particles controlled to have an average particle diameter in a predetermined range.

Piezoelectric ceramics and piezoelectric ceramic resonator of the second embodiment can obtain a larger Qₘₐₓ of "Q" between a resonant frequency and an antiresonant frequency with respect to a third harmonic wave of thickness vertical vibration at 16 to 65 MHz, particularly at 60 MHz.

Below, the second embodiment of the present invention will be explained.
Note that the second embodiment has the same configuration and effects as those in the first embodiment except for the explanation below, and an explanation on the overlapping part will be omitted.

In the piezoelectric ceramic resonator 1 in the second embodiment, the piezoelectric substance layer 2 is different comparing with that in the first embodiment.

The piezoelectric substance layer 2 of the second embodiment includes the piezoelectric ceramics according to the second aspect of the present invention.
The piezoelectric ceramics according to the second aspect include ceramic particles.
The ceramic particles include a main component including a bismuth layer compound and a subcomponent including at least an oxide of Mn.

The bismuth layer compound has a layered configuration that a pseudo-perovskite structure layer is sandwiched by a pair of layers of Bi and O.
In the second embodiment, the bismuth layer compound contains at least Ca, Ln (note that Ln is lanthanoid element), Bi, Ti and O, and includes M^{II}Bi₄Ti₄O₁₅ type crystal. In the second embodiment, M^{II} in the M^{II}Bi₄Ti₄O₁₅ type crystal is an element composed of Ca and Ln and preferably expressed by a composition formula of (Ca_{1-β} Ln_{β})Bi_{γ}Ti₄O₁₅. Note that, in the present invention, an oxygen (O) amount may be a little deviated from the above stoichiometric composition.

In the above composition formula, "β" preferably satisfies 0.01 ≤ β ≤ 0.5, and more preferably 0.03 ≤ β ≤ 0.3. The "β" indicates the number of atoms of Ln. Ln has an effect of improving Qₘₐₓ. Ln indicates a lanthanoid element and the same materials as those in the first embodiment may be used. Note that, in the second embodiment, the Qₘₐₓ means a value in the third harmonic mode of thickness vertical vibration at 60 MHz.

In the above composition formula, "γ" preferably satisfies 3.80 ≤ γ ≤ 4.20, and more preferably 3.90 ≤ γ ≤ 4.15. The "γ" indicates the number of atoms of Bi. When the "γ" is in the above ranges, a mechanical quality coefficient (Qₘ) can be improved. When the γ value is too small, the sinterability declines and the Qₘₐₓ tends to decline, while when too large, the electric resistance declines, so that the polarization becomes difficult and the Qₘₐₓ tends to decline.

A content of Mn oxide may be the same as that in the first embodiment. Also, in the second embodiment, the same impurities and a trace of additives may be included in the same amount as that in the first embodiment.

A characteristic of the second embodiment is that the ceramic particles have an average particle diameter of 1.0 to 4.5 µm. When the average particle diameter of the ceramic particles is in the above range, the Qₘₐₓ of the piezoelectric ceramics in the third harmonic mode of thickness vertical vibration in a relatively high frequency band (for example, 16 to 65 MHz) can be made large. The present inventors have found that the Qₘₐₓ tends to decline when the average particle diameter of the ceramic particles is too small or too large. According to the knowledge of the inventors, this tendency becomes notable in the case of a relatively high measurement frequency (for example, 16 to 65 MHz) comparing with the case of a relatively low measurement frequency (for example, 10 MHz).

Note that the reason why an average particle diameter of the ceramic particles is set to be in the above range is the same as that in the first embodiment.

The lower limit of the average particle diameter is 1.0 µm or larger, preferably 1.1 µm or larger, more preferably 1.3 µm or larger, furthermore preferably 1.4 µm or larger, particularly preferably 1.6 µm or larger, and most preferably 1.8 µm or larger. Also, the upper limit of average particle diameter is 4.5 µm or smaller, preferably 4.2 µm or smaller, more preferably 4.1 µm or smaller, furthermore preferably 4.0 µm or smaller, particularly preferably 3.4 µm or smaller, and most preferably 3.2 µm or smaller. Note that an average particle diameter of the ceramic particles in the second embodiment is measured by the code length measuring method in the same way as in the first embodiment.

In the second embodiment, the ceramic particles are composed to have the above predetermined composition and made to have an average particle diameter of 1.0 to 4.5 µm, so that it is possible to obtain piezoelectric ceramics and a piezoelectric ceramic resonator having a large Qₘₐₓ in the third harmonic mode of thickness vertical vibration. In the second embodiment, since piezoelectric ceramics including ceramic particles as above is used, the Qₘₐₓ in the third harmonic mode of thickness vertical vibration at 60 MHz can be preferably 6 or larger, and more preferably 6.2 or larger.

A thickness of the piezoelectric substance layer 2 is not particularly limited, but is normally 50 to 300 µm or so. Also, in the second embodiment, a polarization direction of the piezoelectric substance layer 2 is the same as a thickness direction of the piezoelectric substance layer 2.

The piezoelectric ceramic resonator 1 of the second embodiment can be produced in the same method as that in the first embodiment except for the explanation below, and an explanation on the overlapping part will be omitted.

First, main component materials and subcomponent materials to compose piezoelectric ceramic material powder are prepared.
In the second embodiment, being different from the first embodiment, oxides of respective elements composing the bismuth layer compound according to the second embodiment explained above and/or compounds which become these oxides after firing are used as the main component materials. Also, as the subcomponent materials, the same materials as those in the first embodiment may be used.

Next, in the same way as in the first embodiment, the main component materials and subcomponent materials are wet mixed, and the obtained material powder is calcined so as to obtain a calcined material. The obtained calcined material is made to be slurry, pulverized and dried to obtain piezoelectric ceramic material powder.

In the second embodiment, being different from the first embodiment, it is preferable that the fine pulverization is performed, so that the 50% diameter (D50 diameter) in cumulative number-size distribution of the piezoelectric ceramic material powder to be obtained becomes preferably 1.1 to 1.85 µm, and more preferably 1.15 to 1.6 µm.

Next, in the same way as in the first embodiment, the piezoelectric ceramic material powder is granulated, then, press molded to be a mold, subjected binder removal processing, then, fired, so that a sintered body of the piezoelectric ceramics is obtained.

In the second embodiment, firing is preferably performed under the condition below. Namely, the firing temperature is preferably 1100 to 1250°C, and more preferably 1150 to 1200°C. Also, the firing time is preferably 1 to 3 hours or so. Note that, in the second embodiment, the reason why the firing temperature is set as above is the same as that in the first embodiment.

Next, in the same way as in the first embodiment, a sintered body of the piezoelectric ceramics obtained by the firing is cut and subjected to polarization processing, so that vibrating electrodes 3 are formed. In the second embodiment, the polarization processing is performed, so that the polarization direction of the sintered body becomes the same as the thickness direction of the piezoelectric substance layer 2.

According to the second embodiment, in the piezoelectric ceramics and the piezoelectric ceramic resonator, it is possible to attain the Qₘₐₓ in the third harmonic mode of thickness vertical vibration at 60 MHz of preferably 6 or larger, and more preferably 6.2 or larger. The reason why the measurement frequency is set to 60 MHz is to deal with a personal computer, particularly, microcomputer control in a hard disk and microcomputer control in a printer, etc. In the case of being used for the use objects, preferably, the piezoelectric ceramics having the Qₘₐₓ in the third harmonic mode of thickness vertical vibration at 60 MHz of 6 or larger is demanded.

Note that, in the second embodiment, a Qₘₐₓ in the third harmonic mode of thickness vertical vibration at 60 MHz was explained, however, the piezoelectric ceramic resonator of the second embodiment has a large Qₘₐₓ also in a frequency band of 16 to 65 MHz or so and may be also suitably used in that frequency band. According to the second embodiment, the Qₘₐₓ at 16 to 25 MHz or so (particularly 16.9 MHz and 20 MHz) can be preferably 8 or larger, the Qₘₐₓ at 25 to 40 MHz or so (particularly 33 MHz) can be preferably 7 or larger, the Qₘₐₓ in 45 to 55 MHz or so (particularly 50 MHz) can be preferably 6.5 or larger, and the Qₘₐₓ in 55 to 65 MHz or so can be preferably 6 or larger.

### Third Embodiment

In the third embodiment, piezoelectric ceramics include at least Ba, Sr, Ln, Bi, Ti and O, a bismuth layer compound including M^{II}Bi₄Ti₄O₁₅ type crystal (M^{II} is an element composed of Ba, Sr and Ln) as the main component, an oxide of Mn and an oxide of Ge as the subcomponent, and ceramic particles controlled to have an average particle diameter in a predetermined range.

Piezoelectric ceramics and piezoelectric ceramic resonator of the third embodiment can obtain a larger Qₘₐₓ of Q between a resonant frequency and an antiresonant frequency with respect to a fundamental wave of thickness-shear vibration at 4 to 12 MHz, particularly at 8 MHz.

Below, the third embodiment of the present invention will be explained.
Note that the third embodiment has the same configuration and effects as those in the first embodiment except for the description below, and an explanation on the overlapping part will be omitted.

In the piezoelectric ceramic resonator 1 in the third embodiment, the piezoelectric substance layer 2 is different comparing with that in the first embodiment.

The piezoelectric substance layer 2 of the third embodiment includes the piezoelectric ceramics according to the third aspect of the present invention.
The piezoelectric ceramics according to the third aspect include ceramic particles.
The ceramic particles include a main component including a bismuth layer compound and a subcomponent including at least an oxide of Mn and an oxide of Ge.

The bismuth layer compound has a layered configuration that a pseudo-perovskite structure layer is sandwiched by a pair of layers of Bi and O.
In the third embodiment, the bismuth layer compound contains at least Ba, Sr, Ln (note that Ln is lanthanoid element), Bi, Ti and O, and includes M^{II}Bi₄Ti₄O₁₅ type crystal. The M^{II} in the M^{II}Bi₄Ti₄O₁₅ type crystal is an element composed of Ba, Sr and Ln and preferably expressed by a composition formula of (Ba_{1-α-β} Sr_{α} Ln_{β})Bi_{γ}Ti₄O₁₅. Note that, in the present invention, an oxygen (O) amount may be a little deviated from the above stoichiometric composition.

In the above composition formula, "α" preferably satisfies 0.1 ≤ α ≤ 0.6, and more preferably 0.2 ≤ α ≤ 0.5. The "α" indicates the number of atoms of Sr. When an α value is too small, it is liable that the sinterability becomes unstable, large holes arise and the Qₘₐₓ declines, while when too large, the Qₘₐₓ declines and the temperature characteristics tend to decline. Note that, in the third embodiment, the Qₘₐₓ means a value in the fundamental wave mode of thickness-shear vibration at 8 MHz.

In the above composition formula, "β" preferably satisfies 0.05 ≤ β ≤ 0.5, and more preferably 0.1 ≤ β ≤ 0.3. The "β" indicates the number of atoms of Ln. Ln has an effect of improving Qₘₐₓ. Here, Ln indicates a lanthanoid element and, particularly, at least one kind of element selected from La, Gd, Sm, Nd and Yb is preferable among lanthanoid elements in the third embodiment. When the β value is too small or too large, the Qₘₐₓ tends to decline.

In the above composition formula, "γ" preferably satisfies 3.90 ≤ γ ≤ 4.30, and more preferably 4.00 ≤ γ ≤ 4.15. The "γ" indicates the number of atoms of Bi. When the "γ" is in the above ranges, a mechanical quality coefficient (Qₘ) can be improved. When the γ value is too small, the sinterability declines and the Qₘₐₓ tends to decline, while when too large, the electric resistance declines, so that the polarization becomes difficult and the Qₘₐₓ tends to decline.

A content of the Mn oxide is preferably 0.1 to 1.0 wt%, and more preferably 0.2 to 0.7 wt% in terms of MnO. When a content of the Mn oxide is too small, the Qₘₐₓ tends to decline, while when too large, it is liable that the insulation resistance declines and the polarization becomes difficult.

A content of the Ge oxide is preferably 0.05 to 0.5 wt%, and more preferably 0.1 to 0.3 wt% in terms of GeO₂. When the content of the Ge oxide is too small, the sinterability tends to decline, while when too large, the Qₘₐₓ tends to decline.

Also, in the third embodiment, the same impurities and a trace of additives in the same amount as that in the first embodiment may be included.

A characteristic of the third embodiment is that the ceramic particles have an average particle diameter of 0.4 to 3.2 µm. When the average particle diameter of the ceramic particles is in the above range, the Qₘₐₓ of the piezoelectric ceramics in the fundamental wave mode of thickness-shear vibration can be made large. The present inventors have found that the Qₘₐₓ tends to decline when the average particle diameter of the ceramic particles is too small or too large.

Note that the reason why an average particle diameter of the ceramic particles is set to be in the above range in the third embodiment is the same as that in the first embodiment.

The lower limit of the average particle diameter is 0.4 µm or larger, preferably 0.45 µm or larger, more preferably 0.5 µm or larger, furthermore preferably 0.6 µm or larger, particularly preferably 0.8 µm or larger, and most preferably 1.0 µm or larger. Also, the upper limit of average particle diameter is 3.2 µm or smaller, preferably 3.1 µm or smaller, more preferably 2.9 µm or smaller, furthermore preferably 2.5 µm or smaller, particularly preferably 2.2 µm or smaller, and most preferably 1.7 µm or smaller. Note that an average particle diameter of the ceramic particles in the third embodiment is measured by the code length measuring method in the same way as in the first embodiment.

In the third embodiment, the ceramic particles are composed to have the above predetermined composition and made to have an average particle diameter of 0.4 to 3.2 µm, so that it is possible to obtain piezoelectric ceramics and a piezoelectric ceramic resonator having a large Qₘₐₓ in the fundamental wave mode of thickness-shear vibration. In the third embodiment, since piezoelectric ceramics including ceramic particles as above is used, the Qₘₐₓ in the fundamental wave mode of thickness-shear vibration at 8 MHz can be preferably 23 or larger, more preferably 25 or larger, and particularly preferably 27 or larger.

A thickness of the piezoelectric substance layer 2 is not particularly limited, but is normally 80 to 350 µm or so. Also, in the third embodiment, a polarization direction of the piezoelectric substance layer 2 is perpendicular to a thickness direction of the piezoelectric substance layer 2 being different from that in the first and second embodiments.

A conductive material included in the vibrating electrodes 3 is not particularly limited and, for example, Ag, etc. may be used in the same way as in the first embodiment, and the shape may be also the same as that in the first embodiment. Note that, in the third embodiment, a thickness of the vibrating electrodes 3 is normally 1 to 8 µm or so.

The piezoelectric ceramic resonator 1 of the third embodiment can be produced in the same method as that in the first embodiment except for the explanation below, and an explanation on the overlapping part will be omitted.

First, main component materials and subcomponent materials to compose piezoelectric ceramic material powder are prepared.
In the third embodiment, being different from the first embodiment, oxides of respective elements composing the bismuth layer compound according to the third embodiment explained above and/or compounds which become these oxides after firing are used as the main component materials. Also, as the subcomponent materials, oxides of respective subcomponents explained above and/or compounds which become these oxides after firing may be used.

Next, in the same way as in the first embodiment, the main component materials and subcomponent materials are wet mixed, and the obtained material powder is calcined so as to obtain a calcined material. The obtained calcined material is made to be slurry, pulverized and dried to obtain piezoelectric ceramic material powder.

In the third embodiment, being different from the first embodiment, it is preferable that the fine pulverization is performed, so that the 50% diameter (D50 diameter) in cumulative number-size distribution of the piezoelectric ceramic material powder to be obtained becomes preferably 0.5 to 1.4 µm, and more preferably 0.6 to 1.2 µm.

Next, in the same way as in the first embodiment, the piezoelectric ceramic material powder is granulated, then, press molded to be a mold, subjected binder removal processing, then, fired, so that a sintered body of the piezoelectric ceramics is obtained.

In the third embodiment, firing is preferably performed under the condition below. Namely, the firing temperature is preferably 1000 to 1200°C, and more preferably 1050 to 1150°C. Also, the firing time is preferably 1 to 8 hours or so. Note that, in the third embodiment, the reason why the firing temperature is set as above is the same as that in the first embodiment.

Next, in the same way as in the first embodiment, a sintered body of the piezoelectric ceramics obtained by the firing is cut and subjected to polarization processing, so that vibrating electrodes 3 are formed. Note that, in the third embodiment, the polarization processing is performed, so that the polarization direction of the sintered body becomes perpendicular to the thickness direction of the piezoelectric substance layer 2 being different from the first and second embodiments.

According to the third embodiment, in the piezoelectric ceramics and the piezoelectric ceramic resonator, it is possible to attain the Qₘₐₓ in the fundamental wave mode of thickness-shear vibration at 8 MHz of preferably 23 or larger, more preferably 25 or larger, and particularly preferably 27 and larger. The reason why the measurement frequency is set to 8 MHz is to deal with an IC control for vehicles and an IC for controlling AV devices, etc. In the case of being used for the use objects, preferably, the piezoelectric ceramics having the Qₘₐₓ in the fundamental wave mode of thickness-shear vibration at 8 MHz of 23 or larger is demanded.

Note that, in the third embodiment, a Qₘₐₓ in the fundamental wave mode of thickness-shear vibration at 8 MHz was explained, however, the piezoelectric element of the third embodiment has a large Qₘₐₓ also in a frequency band of 4 to 12 MHz or so and may be also suitably used in that frequency band. According to the third embodiment, for example, the Qₘₐₓ at 4 to 6 MHz or so can be preferably 17 or larger, and the Qₘₐₓ at 10 to 12 MHz or so can be preferably 23 or larger.

Embodiments of the present invention were explained above, but the present invention is not limited to the above embodiments and may be variously modified within the scope of the present invention.

For example, in the above first to third embodiments, a piezoelectric ceramic resonator was explained as an example of a piezoelectric element according to the present invention, but the piezoelectric element according to the present invention is not limited to a piezoelectric ceramic resonator and may be any as far as it includes a piezoelectric substance layer composed of piezoelectric ceramics having the ceramic particles as above.

Also, in the first to third embodiments, timing of adding subcomponent materials was same as that of main component materials, but the main component materials may be brought to react in advance to obtain a reacted substance and, then, the subcomponent materials may be added.

### EXAMPLES

Below, the present invention will be explained based on further detailed examples, but the present invention is not limited to the examples.

First, examples 1-1 to 1-4 according to the first aspect (first embodiment) of the present invention will be explained.

### Example 1-1

SrCO₃, La₂O₃, Bi₂O₃ and TiO₂ as main component materials and MnCO₃ as subcomponent material were prepared and the main component materials were weighed so as to attain a final composition of the main component of (Sr_{0.9}La_{0.1})Bi_{4.0}Ti₄O₁₅ and the subcomponent material MnCO₃ was weighed, so that content thereof becomes 0.5 wt%. Next, pure water was added, wet mixed for 16 hours by a ball mill in the pure water added with zirconia media, and dried sufficiently to obtain mixed powder.

The obtained mixed powder was temporarily molded and subjected to calcining in the air at 800°C for 2 hours, so that a calcined material was produced. Next, the obtained calcined material was added with pure water, finely pulverized in the pure water by a ball mill in the pure water added with zirconia media, and dried to produce piezoelectric ceramic material powder. Note that when finely pulverizing, time for finely pulverization and a pulverization condition were changed to obtain piezoelectric ceramic material powders, each having different particle diameter (D50 diameter). Note that the particle diameter (D50 diameter) of each piezoelectric ceramic material powder was obtained to measure 50% diameters in cumulative number-size distribution by performing the laser light diffraction method.

The piezoelectric ceramic material powders having different particle diameters were added with 6 wt% of pure water as a binder and press molded to obtain a temporary mold of 40 mm in length × 40 mm in width × 13 mm in thickness, then, after vacuum packing the temporary mold, isostatic pressing with a pressure of 245 MPa was performed to obtain a mold.

Next, the mold was fired at respective temperatures of 1100 to 1225°C to obtain a sintered body. Then, the sintered body was cut and surface processing by lapping was performed to obtain a size of 30 mm in length × 30 mm in width × 0.30 mm in thickness.

On both sides of the sintered body cut as above, Cu electrodes for polarization processing were formed by the vacuum evaporation method, an electric field of at least 1.5 × Ec (MV/m) was applied for one minute in a silicon oil bath at 250°C to perform polarization processing. Note that "Ec" is a coercive electric field of each sintered body at 250°C.

Next, the Cu electrodes were removed from the sintered body subjected to the polarization processing by etching by using a ferric chloride solution, then, the sintered body was cut again by lapping to obtain a piezoelectric ceramic sample in 2.5 mm in length × 2.0 mm in width × 0.25 mm in thickness. Note that, in the present example, the polarization direction of the piezoelectric ceramics sample was made to be the same as a thickness direction thereof.

At the center on both surfaces of the piezoelectric ceramics sample, Ag electrodes having a diameter of 8 mm and a thickness of 1 µm were formed by the vacuum evaporation method, so that piezoelectric ceramic resonator samples using piezoelectric ceramics material powder having different particle diameters and different firing temperatures were obtained.

### Measurement of Particle Diameter of Ceramic Particles

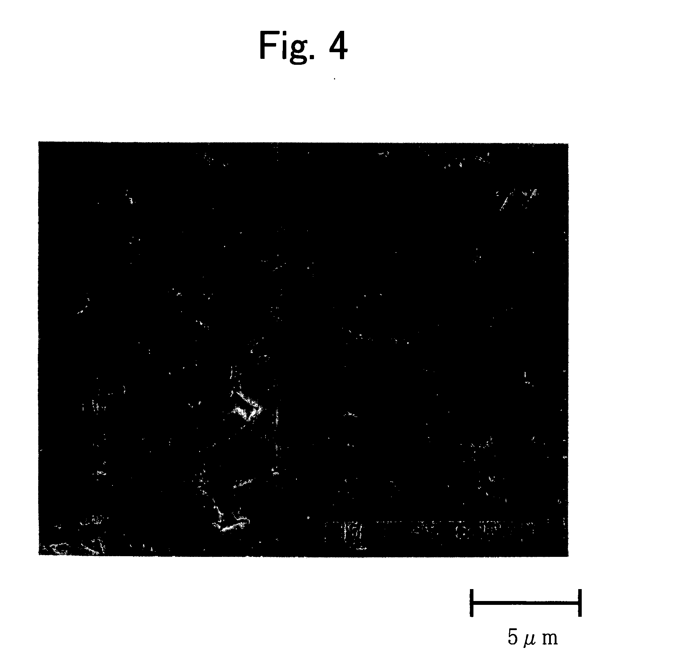

Measurement of particle diameters of ceramic particles composing the piezoelectric substance layer was made. Measurement of a particle diameter was made by first cutting an obtained piezoelectric ceramic resonator sample on a plane perpendicular to the vibrating electrodes, polishing the cut surface, observing the polished surface by a scanning electronic microscope (SEM), and calculating by the code length measuring method on an assumption that a shape of the ceramic particles was sphere. A scope of the SEM was 23 µm × 30 µm, at least 5 SEM pictures were used for one sample, 6 straight lines crossing at an angle of 60° at the center of each SEM picture were drawn, a code length (L3) was measured on particles on the straight lines, and an average particle diameter was obtained. Note that when obtaining an average particle diameter, a constant "k" to be multiplied with the average code length (L3₍ₐᵥₑ₎) was k = 1.5. FIG. 4 shows an example of the SEM pictures used in the particle diameter measurement in the present example. This is a SEM picture of a sample, wherein an average particle diameter by the code length measuring method was 1.83 µm.

### Measurement of Qₘₐₓ

By measuring impedance characteristics of the piezoelectric ceramic samples produced as above in the third harmonic mode of thickness vertical vibration (24 MHz) by using an impedance analyzer (HP4194A made by Hewlett Packard), a Qₘₐₓ was obtained. The Qₘₐₓ was considered preferable when it is 8 or larger.

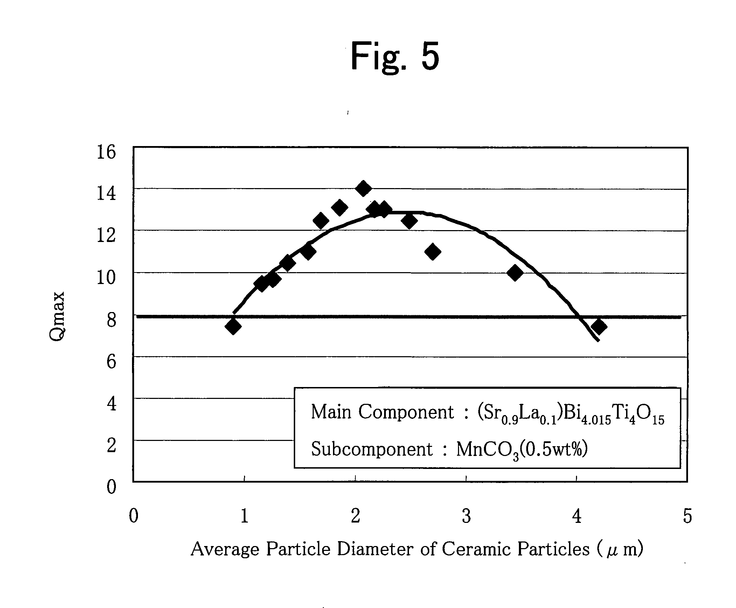

FIG. 5 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 1-1.

From FIG. 5, it was possible to confirm a tendency that a Qₘₐₓ value increases as the average particle diameter increases until the average particle diameter of the ceramic particles reaches 2.5 µm or so, and when the average particle diameter excesses 2.5 µm or so, the Qₘₐₓ value starts to decrease as the average particle diameter increases.

From the result, it was confirmed that the Qₘₐₓ tends to decrease when an average particle diameter of ceramic particles composing a piezoelectric substance is too small or too large in piezoelectric ceramic resonator samples.

In the example 1-1, preferable result of the Qₘₐₓ exceeding 8 was obtained in samples, wherein an average particle diameter of the ceramic particles was 0.8 to 4.7 µm. Among them, particularly preferable result of the Qₘₐₓ exceeding 10 was obtained in samples, wherein an average particle diameter of the ceramic particles was 1.3 to 3.6 µm.

### Example 1-2

Other than changing a ratio of Sr and La in the main component and the final composition of the main component to (Sr_{0.93}La_{0.07})Bi_{4.015}Ti₄O₁₅, piezoelectric ceramic resonator samples using piezoelectric ceramics material powder having different particle diameters and fired at different firing temperatures were produced in the same way as in the example 1-1.

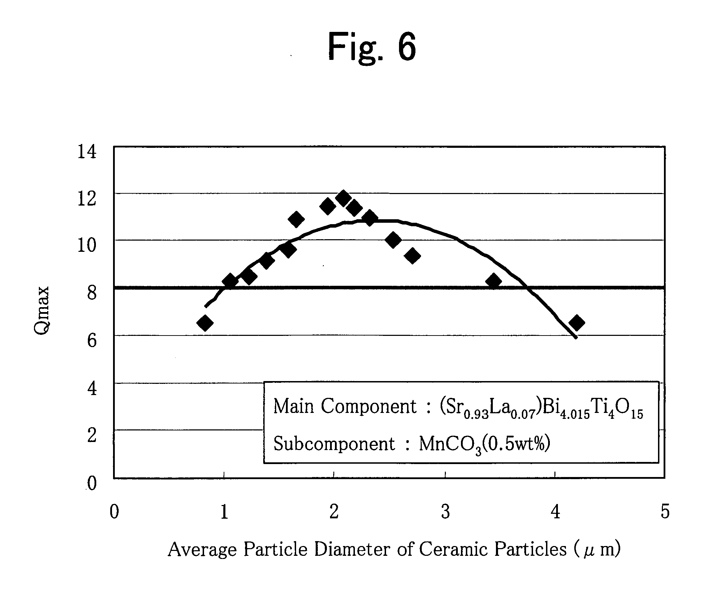

FIG. 6 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 1-2.

From FIG. 6, even in the case of using piezoelectric ceramics having ceramic particles, wherein a ratio of Sr and La is changed and a composition of the main component is changed to (Sr_{0.93}La_{0.07})Bi_{4.015}Ti₄O₁₅, it was confirmed that the Qₘₐₓ value tends to decrease when an average particle diameter of ceramic particles is too small or too large in the same way as in the example 1-1.

In the example 1-2, samples with ceramic particles having an average particle diameter of 1.0 to 3.7 µm exhibited preferable result that the Qₘₐₓ exceeded 8. Among them, samples with ceramic particles having an average particle diameter of 1.7 to 2.5 µm exhibited particularly preferable result that the Qₘₐₓ exceeded 10.

### Example 1-3

Other than using Gd₂O₃ instead of La₂O₃ as the main component material and changing the final composition of the main component to (Sr_{0.9}Gd_{0.1})Bi_{4.015}Ti₄O₁₅, piezoelectric ceramic resonator samples using piezoelectric ceramics material powder fired at different particle diameters and having different firing temperatures were produced in the same way as in the example 1-1.

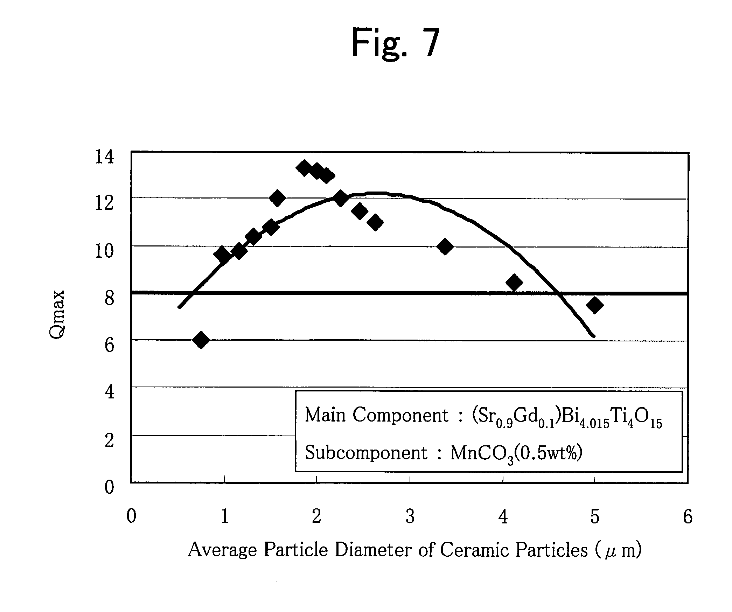

FIG. 7 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 1-3.

From FIG. 7, respective piezoelectric ceramic resonator samples in the example 1-3 using piezoelectric ceramics having ceramic particles, wherein a composition of the main component is changed to (Sr_{0.9}Gd_{0.1})Bi_{4.015}Ti₄O₁₅, it was confirmed that the Qₘₐₓ value tends to decrease when an average particle diameter of ceramic particles is too small or too large in the same way as in the examples 1-1 and 1-2.

In the example 1-3, samples with ceramic particles having an average particle diameter of 0.8 to 4.6 µm exhibited preferable result that the Qₘₐₓ exceeded 8. Among them, samples with ceramic particles having an average particle diameter of 1.3 to 3.3 µm exhibited particularly preferable result that the Qₘₐₓ exceeded 10.

### Example 1-4

Other than changing a content of MnCO₃ as the subcomponent material to 0.6 wt%, piezoelectric ceramic resonator samples using piezoelectric ceramics material powder having different particle diameters and fired at different firing temperatures were produced in the same way as in the example 1-1.

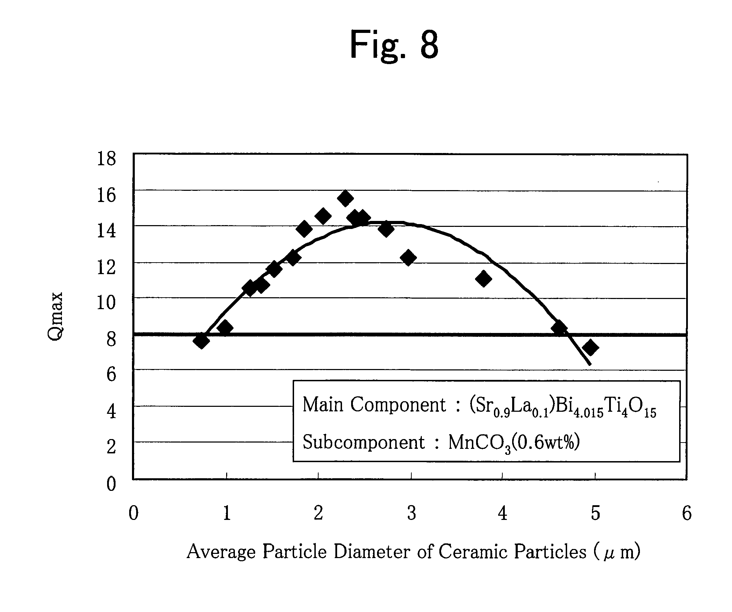

FIG. 8 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 1-4.

From FIG. 8, piezoelectric ceramic resonator samples in the example 1-4 using piezoelectric ceramics having ceramic particles, wherein a content of MnCO₃ was changed to 0.6 wt%, was confirmed that the Qₘₐₓ value tends to decrease when an average particle diameter of ceramic particles is too small or too large in the same way as in the examples 1-1 to 1-3.

In the example 1-4, samples with ceramic particles having an average particle diameter of 0.8 to 4.7 µm exhibited preferable result that the Qₘₐₓ exceeded 8. Among them, samples with ceramic particles having an average particle diameter of 1.3 to 4.2 µm exhibited particularly preferable result that the Qₘₐₓ exceeded 10.

Next, examples 2-1 to 2-4 according to the second aspect (second embodiment) of the present invention will be explained.

### Example 2-1

First, CaCO₃, La₂O₃, Bi₂O₃ and TiO₂ as main component materials and MnO as subcomponent material were prepared and the main component materials were weighed so as to attain a final composition of the main component of (Ca_{0.97}La_{0.03})Bi_{4.01}Ti₄O₁₅ and the subcomponent material MnO was weighed, so that a content thereof becomes 0.5 wt%.

Next, in the same way as in the example 1-1, mixed powder was obtained and made to be temporarily molded and subjected to calcining, so that a calcined material was obtained. Then, the obtained calcined material was subjected to fine pulverization and dried, so that piezoelectric ceramics material powder was produced. Note that, in the present example, in the same way as in the example 1-1, by changing time for finely pulverization and a pulverization condition, piezoelectric ceramic material powders, each having different particle diameter (D50 diameter), were obtained.

In the same way as in the example 1-1, by using the piezoelectric ceramic material powders having different particle diameters, molds were obtained and fired at respective temperatures of 1150 to 1200°C so as to obtain sintered bodies.

After that, in the same way as in the example 1-1, the obtained sintered body was cut and polished by lapping to obtain a size of 30 mm in length × 30 mm in width × 0.25 mm in thickness. Then, polarization processing was performed to form Ag electrodes, so that piezoelectric ceramic resonator samples using piezoelectric ceramics material powder having different particle diameters and fired at different firing temperatures were obtained.

Note that, in the present example, a size of the piezoelectric ceramic samples was 2.5 mm in length × 2.0 mm in width × 0.12 mm in thickness in the same way as in the example 1-1, and the Ag electrode had a diameter of 1.4 mm and a thickness of 1 µm. Also, in the example 2-1, the polarization direction of the piezoelectric ceramics sample was made to be the same as a thickness direction thereof in the same way as in the example 1-1.

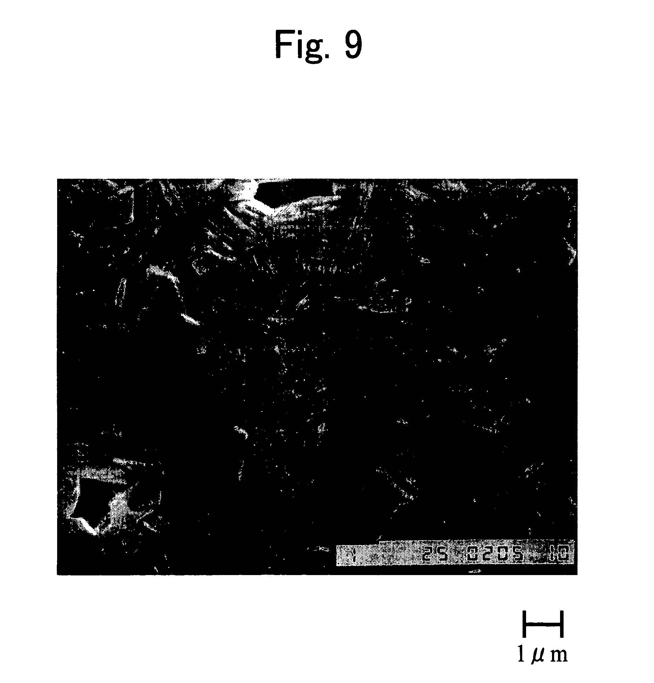

Measurement of particle diameters of the ceramic particles was made on the obtained piezoelectric ceramic resonator samples by the same method as that in the example 1-1. Note that FIG. 9 is an example of a SEM picture used in the particle diameter measurement in the present example. This is a SEM picture of a sample wherein an average particle diameter by the code length measuring method was 2.18 µm. Also, measurement of a Qₘₐₓ was made by the same method as that in the example 1-1 other than measuring under a condition of the third harmonic mode of thickness vertical vibration (60 MHz).

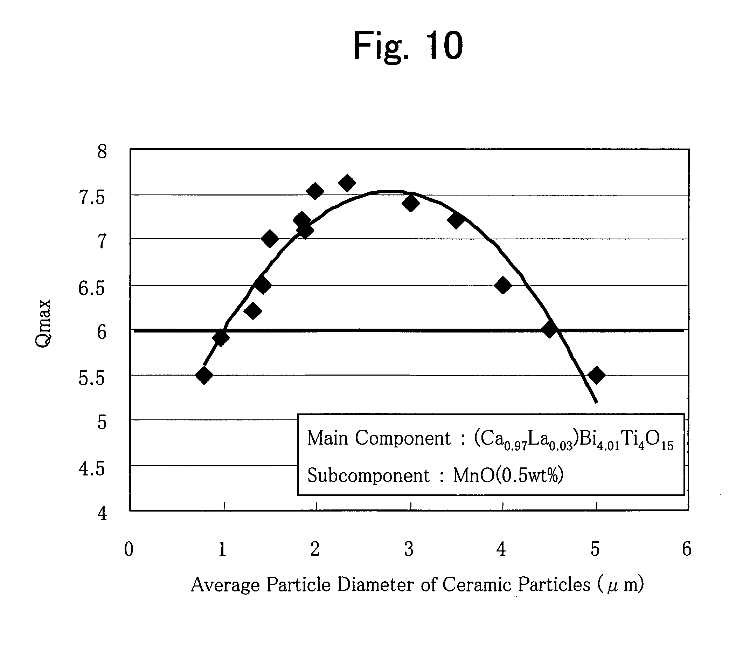

FIG. 10 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 2-1. From FIG. 10, it was confirmed that there was a tendency that a Qₘₐₓ value increases as the average particle diameter increases until the average particle diameter of the ceramic particles reaches 2.9 µm or so, and when the average particle diameter excesses 2.9 µm or so, the Qₘₐₓ value starts to decrease as the average particle diameter increases.

From the result, it was confirmed that the Qₘₐₓ tends to decrease when an average particle diameter of ceramic particles composing a piezoelectric substance is too small or too large in piezoelectric ceramic resonator samples.

In the example 2-1, preferable result of the Qₘₐₓ exceeding 6 was obtained in samples, wherein an average particle diameter of the ceramic particles was 1.0 to 4.5 µm. Among them, particularly preferable result of the Qₘₐₓ exceeding 6.5 was obtained in samples, wherein an average particle diameter of the ceramic particles was 1.3 to 4.2 µm.

### Example 2-2

Other than changing a ratio of Ca and La in the main component and the final composition of the main component to (Ca_{0.9}La_{0.1})Bi_{4.01}Ti₄O₁₅, piezoelectric ceramic resonator samples using piezoelectric ceramics material powder having different particle diameters and fired at different firing temperatures were produced in the same way as in the example 2-1.

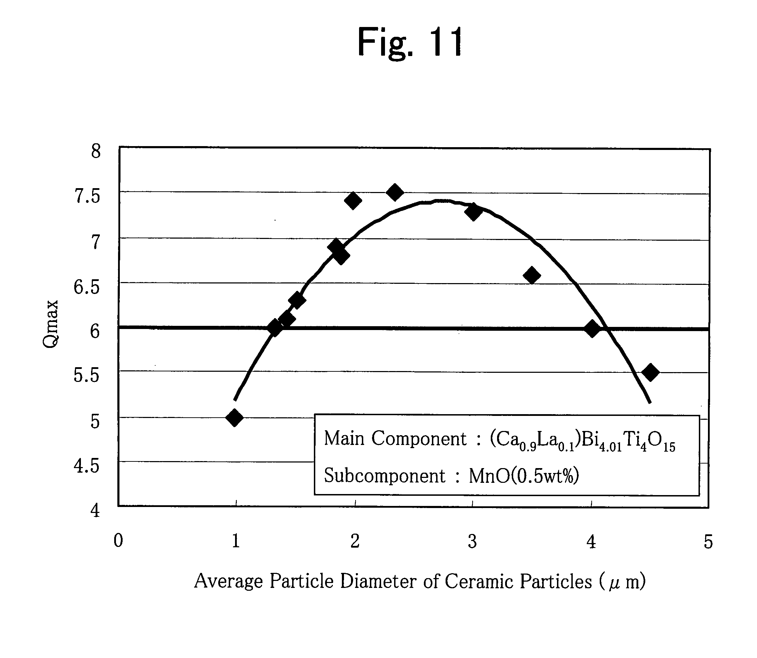

FIG. 11 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 2-2.

From FIG. 11, even in the case of using piezoelectric ceramics having ceramic particles, wherein a ratio of Ca and La is changed and a composition of the main component is changed to (Ca_{0.9}La_{0.1})Bi_{4.01}Ti₄O₁₅, it was confirmed that the Qₘₐₓ value tends to decrease when an average particle diameter of ceramic particles composing a piezoelectric substance is too small or too large.

In the example 2-2, samples with ceramic particles having an average particle diameter of 1.3 to 4.1 µm exhibited preferable result that the Qₘₐₓ exceeded 6. Among them, samples with ceramic particles having an average particle diameter of 1.6 to 3.8 µm exhibited particularly preferable result that the Qₘₐₓ exceeded 6.5.

### Example 2-3

Other than using Pr₂O₃ instead of La₂O₃ as the main component material and changing the final composition of the main component to (Ca_{0.9}Pr_{0.1})Bi_{4.01}Ti₄O₁₅, piezoelectric ceramic resonator samples using piezoelectric ceramics material powder having different particle diameters and fired at different firing temperatures were produced in the same way as in the example 2-1.

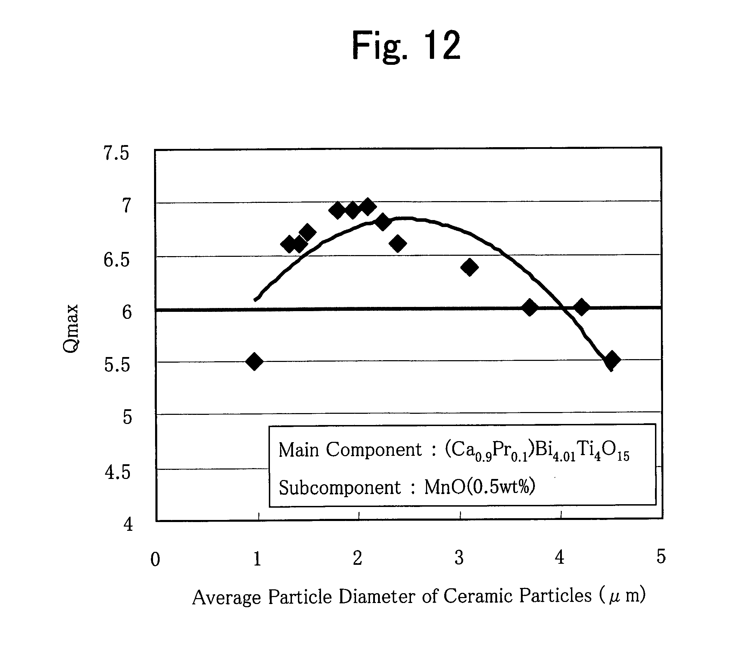

FIG. 12 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 2-3.

From FIG. 12, respective piezoelectric ceramic resonator samples in the example 2-3 using piezoelectric ceramics having ceramic particles, wherein a composition of the main component was changed to (Ca_{0.9}Pr_{0.1})Bi_{4.01}Ti₄O₁₅, it was confirmed that the Qₘₐₓ value tends to decrease when an average particle diameter of ceramic particles is too small or too large in the same way as in the examples 2-1 and 2-2.

In the example 2-3, samples with ceramic particles having an average particle diameter of 1.1 to 4.0 µm exhibited preferable result that the Qₘₐₓ exceeded 6. Among them, samples with ceramic particles having an average particle diameter of 1.5 to 3.4 µm exhibited particularly preferable result that the Qₘₐₓ exceeded 6.5.

### Example 2-4

Other than changing a content of MnO as the subcomponent material to 0.3 wt%, piezoelectric ceramic resonator samples using piezoelectric ceramics material powder having different particle diameters and fired at different firing temperatures were produced in the same way as in the example 2-2.

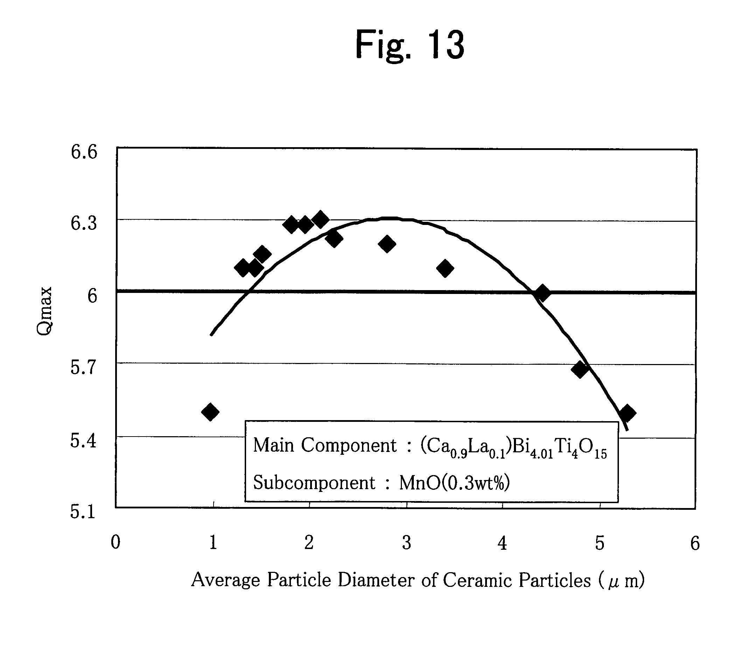

FIG. 13 is a graph showing a relationship of an average particle diameter of ceramic particles composing the piezoelectric substance and a Qₘₐₓ in the third harmonic mode of thickness vertical vibration of a piezoelectric ceramic resonator sample in piezoelectric ceramic resonator samples produced in the example 2-4.

From FIG. 13, piezoelectric ceramic resonator samples in the example 2-4 using piezoelectric ceramics having ceramic particles, wherein a content of MnO was changed to 0.3 wt%, it was confirmed that the Qₘₐₓ value tends to decrease when an average particle diameter of ceramic particles is too small or too large in the same way as in the examples 2-1 to 2-3.

In the example 2-4, samples with ceramic particles having an average particle diameter of 1.4 to 4.2 µm exhibited preferable result that the Qₘₐₓ exceeded 6.

Next, examples 3-1 to 3-5 according to the third aspect (third embodiment) of the present invention will be explained.

### Example 3-1

First, BaCO₃, SrCO₃, La₂O₃, Bi₂O₃ and TiO₂ as main component materials and MnO and GeO₂ as subcomponent materials were prepared and the main component materials were weighed so as to attain a final composition of the main component of (Ba_{0.6}Sr_{0.3}La_{0.1})Bi_{4.033}Ti₄O₁₅ and the subcomponent material MnO was weighed, so that a content thereof becomes 0.3 wt% and GeO₂ to be a content of 0.15 wt%.

Next, in the same way as in the example 1-1, mixed powder was obtained and made to be temporarily molded and subjected to calcining, so that a calcined material was obtained. Then, the obtained calcined material was subjected to fine pulverization and dried, so that piezoelectric ceramics material powder was produced. Note that, in the present example, in the same way as in the example 1-1, by changing time for finely pulverization and a pulverization condition, piezoelectric ceramic material powders, each having different particle diameter (D50 diameter), were obtained.

In the same way as in the example 1-1, by using the piezoelectric ceramic material powders having different particle diameters, molds were obtained and fired at respective temperatures of 1100 to 1150°C so as to obtain sintered bodies.

After that, in the same way as in the example 1-1, the obtained sintered body was cut and polished by lapping to obtain a size of 30 mm in length × 30 mm in width × 0.25 mm in thickness. Then, polarization processing was performed to form Ag electrodes, so that piezoelectric ceramic resonator samples using piezoelectric ceramics material powder having different particle diameters and fired at different firing temperatures were obtained.

Note that, in the present example, a size of the piezoelectric ceramic samples was 2.5 mm in length × 2.0 mm in width × 0.12 mm in thickness and the Ag electrode had a diameter of 1.4 mm and a thickness of 1 µm. Also, in the example 3-1, the polarization direction of the piezoelectric ceramics sample was made to be perpendicular to a thickness direction of the piezoelectric ceramics sample being different from the case in the example 1-1.

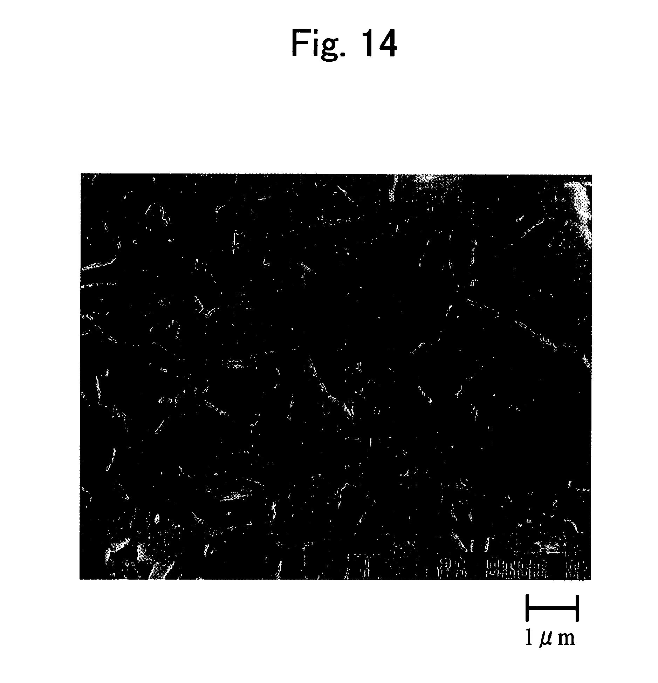

Measurement of particle diameters of the ceramic particles was made on the obtained piezoelectric ceramic resonator samples by the same method as that in the example 1-1. Note that FIG. 14 is an example of a SEM picture used in the particle diameter measurement in the present example. This is a SEM picture of a sample wherein an average particle diameter by the code length measuring method was 1.17 µm. Also, measurement of a Qₘₐₓ was made by the same method as that in the example 1-1 other than measuring under a condition of the fundamental wave mode of thickness-shear vibration (8 MHz).

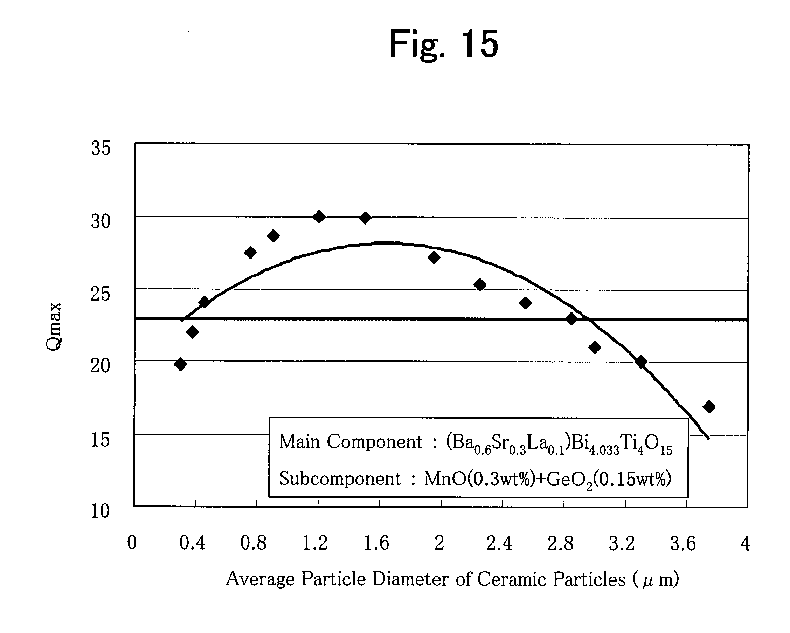

FIG. 15 is a graph showing a relationship of an average particle diameter of ceramic particles composing the piezoelectric substance and a Qₘₐₓ in the fundamental wave mode of thickness-shear vibration of a piezoelectric ceramic resonator sample in piezoelectric ceramic resonator samples produced in the example 3-1. From FIG. 15, it was confirmed that there was a tendency that a Qₘₐₓ value increases as the average particle diameter increases until the average particle diameter of the ceramic particles reaches 1.6 µm or so, and when the average particle diameter excesses 1.6 µm or so, the Qₘₐₓ value starts to decrease as the average particle diameter increases.

From the result, it was confirmed that the Qₘₐₓ tends to decrease when an average particle diameter of ceramic particles composing a piezoelectric substance is too small or too large in piezoelectric ceramic resonator samples.

In the example 3-1, preferable result of the Qₘₐₓ exceeding 23 was obtained in samples, wherein an average particle diameter of the ceramic particles was 0.4 to 2.9 µm. Among them, particularly preferable result of the Qₘₐₓ exceeding 27 was obtained in samples, wherein an average particle diameter of the ceramic particles was 0.8 to 1.9 µm.

### Example 3-2

Other than changing a ratio of Ba and Sr in the main component and the final composition of the main component to (Ba_{0.3}Sr_{0.6}La_{0.1})Bi_{4.033}Ti₄O₁₅, piezoelectric ceramic resonator samples using piezoelectric ceramics material powder having different particle diameters and fired at different firing temperatures were produced in the same way as in the example 3-1.

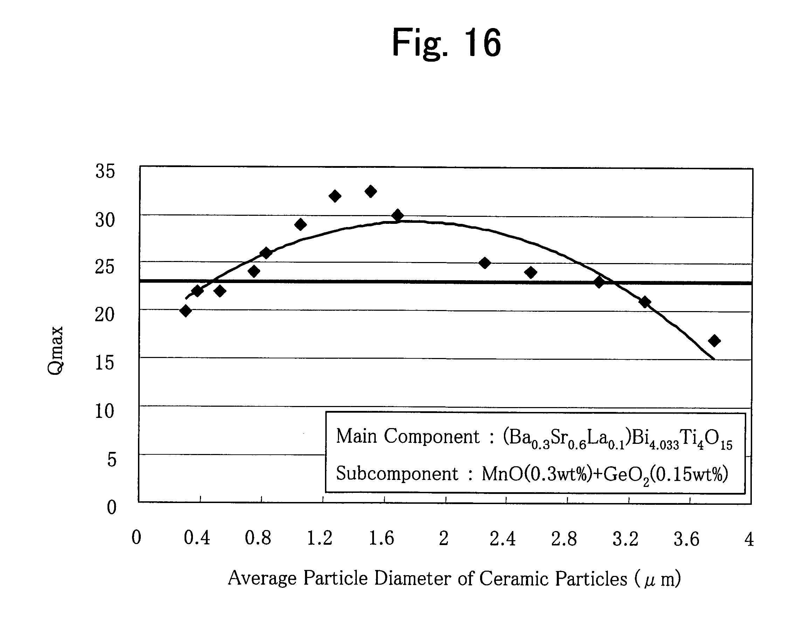

FIG. 16 is a graph showing a relationship of an average particle diameter of ceramic particles composing the piezoelectric substance and a Qₘₐₓ in the fundamental wave mode of thickness-shear vibration of a piezoelectric Ceramic resonator sample in piezoelectric ceramic resonator samples produced in the example 3-1.

From FIG. 16, even in the case of using piezoelectric ceramics having ceramic particles, wherein a ratio of Ba and Sr was changed and a composition of the main component was changed to (Ba_{0.3}Sr_{0.6}La_{0.1})Bi_{4.033}Ti₄O₁₅, it was confirmed that the Qₘₐₓ value tends to decrease when an average particle diameter of ceramic particles is too small or too large.

In the example 3-1, samples with ceramic particles having an average particle diameter of 0.45 to 3.1 µm exhibited preferable result that the Oₘₐₓ exceeded 23. Among them, samples with ceramic particles having an average particle diameter of 0.8 to 1.7 µm exhibited particularly preferable result that the Qₘₐₓ exceeded 27.

### Example 3-3

Other than using Sm₂O₃ instead of La₂O₃ as the main component and changing the final composition of the main component to (Ba_{0.6}Sr_{0.3}Sm_{0.1})Bi_{4.033}Ti₄O₁₅, piezoelectric ceramic resonator samples using piezoelectric ceramics material powder having different particle diameters and fired at different firing temperatures were produced in the same way as in the example 3-1.

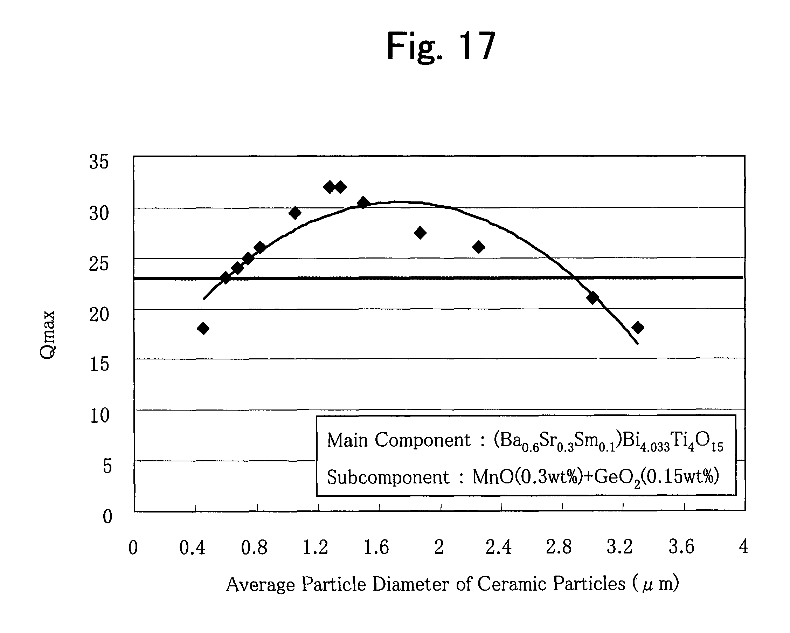

FIG. 17 is a graph showing a relationship of an average particle diameter of ceramic particles composing the piezoelectric substance and a Qₘₐₓ in the fundamental wave mode of thickness-shear vibration of a piezoelectric ceramic resonator sample in piezoelectric ceramic resonator samples produced in the example 3-3.

From FIG. 17, respective piezoelectric ceramic resonator samples in the example 3-3 using piezoelectric ceramics having ceramic particles, wherein a composition of the main component was changed to (Ba_{0.6}Sr_{0.3}Sm_{0.1})Bi_{4.033}Ti₄O₁₅, it was confirmed that the Qₘₐₓ value tends to decrease when an average particle diameter of ceramic particles is too small or too large in the same way as in the examples 3-1 and 3-2.

In the example 3-3, samples with ceramic particles having an average particle diameter of 0.6 to 2.9 µm exhibited preferable result that the Oₘₐₓ exceeded 23. Among them, samples with ceramic particles having an average particle diameter of 1.0 to 1.8 µm exhibited particularly preferable result that the Qₘₐₓ exceeded 27.

### Example 3-4

Other than changing a content of MnO as the subcomponent material to 0.6 wt%, changing a ratio of Ba and Sr in the main component, and changing a composition of the main component to (Ba_{0.4}Sr_{0.5}La_{0.1})Bi_{4.033}Ti₄O₁₅, piezoelectric ceramic resonator samples using piezoelectric ceramics material powder having different particle diameters and fired at different firing temperatures were produced in the same way as in the example 3-1.

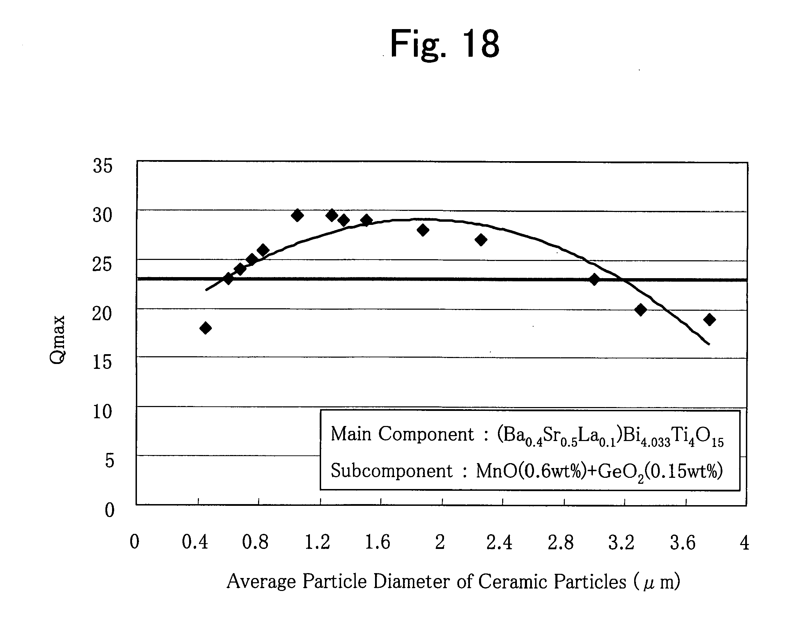

FIG. 18 is a graph showing a relationship of an average particle diameter of ceramic particles composing the piezoelectric substance and a Qₘₐₓ in the fundamental wave mode of thickness-shear vibration of a piezoelectric ceramic resonator sample in piezoelectric ceramic resonator samples produced in the example 3-4.

From FIG. 18, piezoelectric ceramic resonator samples using piezoelectric ceramics having ceramic particles, wherein a content of MnO was changed to 0.6 wt%, it was confirmed that the Qₘₐₓ value tends to decrease when an average particle diameter of ceramic particles is too small or too large in the same way as in the examples 3-1 to 3-3.

In the example 3-4, samples with ceramic particles having an average particle diameter of 0.5 to 3.2 µm exhibited preferable result that the Qₘₐₓ exceeded 23. Among them, samples with ceramic particles having an average particle diameter of 1.0 to 2.2 µm exhibited particularly preferable result that the Qₘₐₓ exceeded 27.

### Example 3-5

Other than changing a content of GeO₂ as the subcomponent material to 0.20 wt%, in the same way as in the example 3-1, piezoelectric ceramic resonator samples using piezoelectric ceramics material powder having different particle diameters and fired at different firing temperatures were produced.

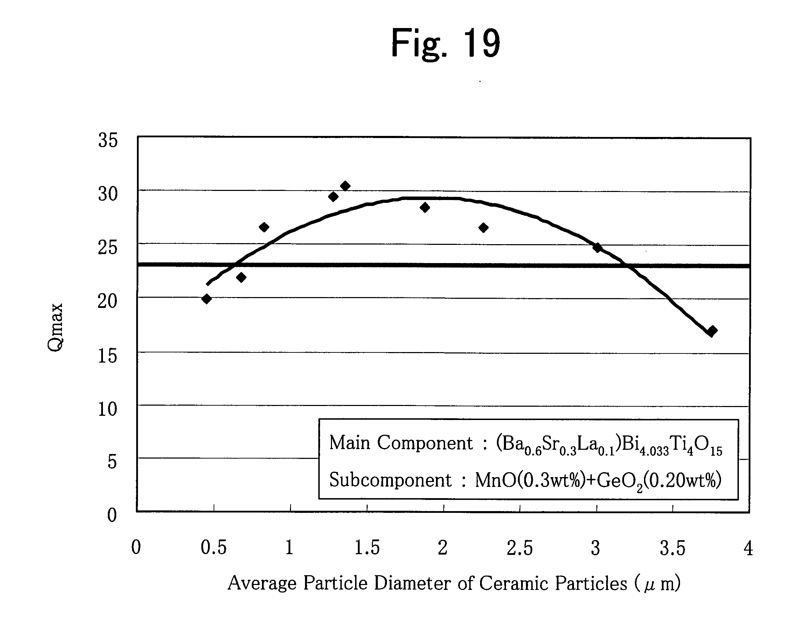

FIG. 19 is a graph showing a relationship of an average particle diameter of ceramic particles composing the piezoelectric substance and a Qₘₐₓ in the fundamental wave mode of thickness-shear vibration of a piezoelectric ceramic resonator sample in piezoelectric ceramic resonator samples produced in the example 3-5.

From FIG. 19, piezoelectric ceramic resonator samples using piezoelectric ceramics having ceramic particles, wherein a content of GeO₂ was changed to 0.20 wt%, it was confirmed that the Qₘₐₓ value tends to decrease when an average particle diameter of ceramic particles is too small or too large in the same way as in the examples 3-1 to 3-4.

In the example 3-5, samples with ceramic particles having an average particle diameter of 0.65 to 3.15 µm exhibited preferable result that the Qₘₐₓ exceeded 23. Among them, samples with ceramic particles having an average particle diameter of 1.0 to 2.5 µm exhibited particularly preferable result that the Qₘₐₓ exceeded 27.

## Claims

1. A piezoelectric ceramics having ceramic particles, wherein:
said ceramic particles comprises
bismuth layer compound containing at least Sr, Ln (note that Ln is a lanthanoid element), Bi, Ti and O and including M^{II}Bi₄Ti₄O₁₅ type crystal (M^{II} is an element composed of Sr and Ln) as a main component, and
an oxide of Mn as a subcomponent; and
an average particle diameter by the code length measuring method is 0.8 to 4.7 µm.

2. The piezoelectric ceramics as set forth in claim 1, wherein said M^{II}Bi₄Ti₄O₁₅ type crystal is expressed by a composition formula (Sr_{α}Ln_{β})Bi_{γ}Ti₄O₁₅, and "α" satisfies α = 1-β, "β" satisfies 0.01 ≤ β ≤ 0.50 and "γ" satisfies 3.80 ≤ γ ≤ 4.50.

3. The piezoelectric ceramics as set forth in claim 1 or 2, wherein a content of said oxide of Mn is 0.1 to 1.0 wt% in terms of MnO.

4. A piezoelectric element, comprising a piezoelectric substance formed by the piezoelectric ceramics as set forth in any one of claims 1 to 3.

5. The piezoelectric element as set forth in claim 4, wherein a maximum value Qₘₐₓ of "Q" (Q = |X|/R, wherein "X" is reactance and "R" is resistance) between a resonant frequency and an antiresonant frequency with respect to a third harmonic wave of thickness vertical vibration at 24 MHz is 8 or larger.

6. A piezoelectric ceramics having ceramic particles, wherein:
said ceramic particles comprises
bismuth layer compound containing at least Ca, Ln (note that Ln is a lanthanoid element), Bi, Ti and O and including M^{II}Bi₄Ti₄O₁₅ type crystal (M^{II} is an element composed of Ca and Ln) as a main component, and
an oxide of Mn as a subcomponent; and
an average particle diameter by the code length measuring method is 1.0 to 4.5 µm.

7. The piezoelectric ceramics as set forth in claim 6, wherein said M^{II}Bi₄Ti₄O₁₅ type crystal is expressed by a composition formula (Ca_{1-β}Ln_{β})Bi_{γ}Ti₄O₁₅, and "β" satisfies 0.01 ≤ β ≤ 0.5 and "γ" satisfies 3.80 ≤ γ ≤ 4.20.

8. The piezoelectric ceramics as set forth in claim 6 or 7, wherein a content of said oxide of Mn is 0.1 to 1.0 wt% in terms of MnO.

9. A piezoelectric element, comprising a piezoelectric substance formed by the piezoelectric ceramics as set forth in any one of claims 6 to 8.

10. The piezoelectric element as set forth in claim 9, wherein a maximum value Qₘₐₓ of "Q" (Q = |X|/R, wherein "X" is reactance and "R" is resistance) between a resonant frequency and an antiresonant frequency with respect to a third harmonic wave of thickness vertical vibration at 60 MHz is 6 or larger.

11. A piezoelectric ceramics having ceramic particles, wherein:
said ceramic particles comprises
bismuth layer compound containing at least Ba, Sr, Ln (note that Ln is a lanthanoid element), Bi, Ti and O and including M^{II}Bi₄Ti₄O₁₅ type crystal (M^{II} is an element composed of Ba, Sr and Ln) as a main component, and
an oxide of Mn and an oxide of Ge as a subcomponent; and
an average particle diameter by the code length measuring method is 0.4 to 3.2 µm.

12. The piezoelectric ceramics as set forth in claim 11, wherein
said M^{II}Bi₄Ti₄O₁₅ type crystal is expressed by a composition formula (Ba_{1-α-β}Sr_{α}Ln_{β})Bi_{γ}Ti₄O₁₅, and
"α" satisfies 0.1 ≤ α ≤ 0.6, "β" satisfies 0.05 ≤ β ≤ 0.5 and "γ" satisfies 3.90 ≤ γ ≤ 4.30 in said composition formula.

13. The piezoelectric ceramics as set forth in claim 11 or 12, wherein
a content of said oxide of Mn is 0.1 to 1.0 wt% in terms of MnO, and
a content of said oxide of Ge is 0.05 to 0.5 wt% in terms of GeO₂.

14. A piezoelectric element, comprising a piezoelectric substance formed by the piezoelectric ceramics as set forth in any one of claims 11 to 13.

15. The piezoelectric element as set forth in claim 14, wherein a maximum value Oₘₐₓ of "Q" (Q = |X|/R, wherein "X" is reactance and "R" is resistance) between a resonant frequency and an antiresonant frequency with respect to the fundamental wave of thickness-shear vibration at 8 MHz is 23 or larger.
